(19) **Europäisches Patentamt European Patent Office Office européen des brevets**

(11) **EP 3 843 162 B1**

(12) **FASCICULE DE BREVET EUROPEEN**

(45) Date de publication et mention de la délivrance du brevet:
**28.09.2022 Bulletin 2022/39**

(51) Classification Internationale des Brevets (IPC):
*H01L 33/44* (2010.01)    *H01L 33/02* (2010.01)
*H01L 33/40* (2010.01)

(21) Numéro de dépôt: **20215891.1**

(22) Date de dépôt: **21.12.2020**

(52) Classification Coopérative des Brevets (CPC):
**H01L 33/44; H01L 33/02;** H01L 33/405;
H01L 2933/0025; H01L 2933/0091

(54) **PROCEDE DE FABRICATION D'UNE DIODE ELECTROLUMINESCENTE A COUCHE D'EXTRACTION COMPORTANT UNE ETAPE DE DIMENSIONNEMENT D'UNE COUCHE SEMICONDUCTRICE**

VERFAHREN ZUR HERSTELLUNG EINER LEUCHTDIODE MIT EINER EXTRAKTIONSSCHICHT, DAS EINEN DIMENSIONIERUNGSSCHRITT EINER HALBLEITERSCHICHT UMFASST

METHOD FOR MANUFACTURING A LIGHT-EMITTING DIODE WITH EXTRACTION LAYER COMPRISING A STEP OF SIZING OF A SEMICONDUCTOR LAYER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.12.2019 FR 1915503**

(43) Date de publication de la demande:
**30.06.2021 Bulletin 2021/26**

(73) Titulaire: **Commissariat à l'Energie Atomique et aux Energies Alternatives**
**75015 Paris (FR)**

(72) Inventeurs:
- **LE BLEVENNEC, Gilles**
  **38054 GRENOBLE Cedex 09 (FR)**
- **BEN BAKIR, Badhise**
  **38054 GRENOBLE Cedex 09 (FR)**
- **SARELLI, Eirini**
  **38054 GRENOBLE Cedex 09 (FR)**

(74) Mandataire: **INNOV-GROUP**
**310, avenue Berthelot**
**69372 Lyon Cedex 08 (FR)**

(56) Documents cités:
EP-A1- 2 362 448      EP-A2- 1 855 327
US-A1- 2012 153 254      US-A1- 2014 008 676

EP 3 843 162 B1

**Description**

**DOMAINE TECHNIQUE**

Le domaine de l'invention est celui des procédés de fabrication de diodes électroluminescentes comportant un empilement semiconducteur de couches inorganiques ou organiques, dont une couche active émissive, ainsi qu'une couche d'extraction.

**ÉTAT DE LA TECHNIQUE ANTÉRIEURE**

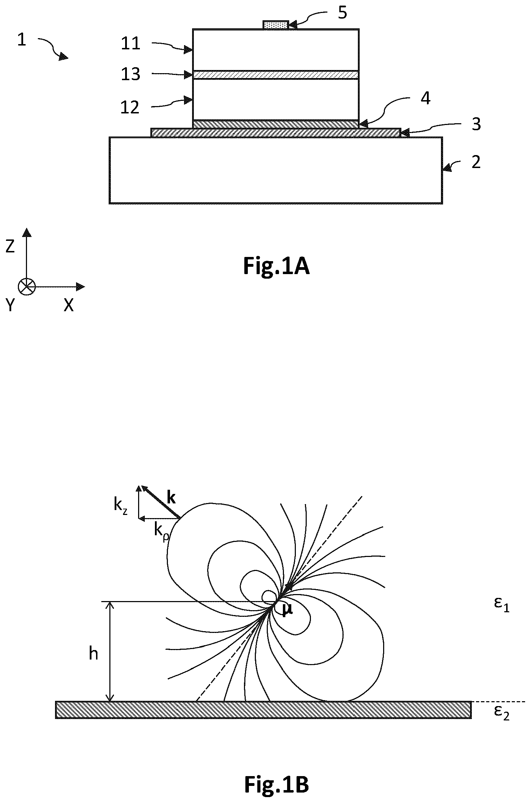

La figure 1A illustre de manière partielle et schématique un exemple d'une diode électroluminescente 1 comportant un empilement de couches semiconductrices, ici inorganiques, dont une première couche 11 dopée N, une deuxième couche 12 dopée P, et une couche active 13 disposée entre les deux couches dopées 11, 12 et au niveau de laquelle est émis l'essentiel du rayonnement lumineux.

La diode électroluminescente 1 repose ici sur un substrat 2 comportant une couche conductrice 3, au contact de laquelle se situe une électrode 4 avantageusement réflectrice formant l'anode. Une électrode 5 de préférence transparente formant une cathode repose sur la couche 11 dopée N. L'électrode réflectrice 4 est de préférence réalisée en un matériau métallique.

La couche active 13 peut être formée, dans le cas d'une jonction PN, par l'interface des deux couches dopées 11, 12 au contact l'une de l'autre, ou dans le cas d'une jonction PIN, par au moins une couche intrinsèque 13 (i.e. non intentionnellement dopée) pouvant comporter un ou plusieurs puits quantiques. Chaque puits quantique peut être formé par une couche présentant une énergie de bande interdite plus faible que celle des deux couches barrières entre lesquelles elle est située, ou peut être formé par des boîtes quantiques (*quantum dots,* en anglais).

Les porteurs de charge (électrons et trous) sont introduits dans l'empilement semiconducteur par les électrodes 4, 5, puis diffusent jusqu'à la couche active 13 où ils se recombinent de manière radiative. Le rayonnement lumineux associé aux recombinaisons radiatives des paires électron-trou dans la couche active 13 correspond au rayonnement dipolaire électrique émis par un dipôle dit émetteur qui oscille de manière harmonique suivant l'axe de son moment dipolaire **μ** (également appelé TDMV, pour *Transition Dipole Moment Vector*, en anglais).

La figure 1B illustre de manière schématique un dipôle émetteur situé dans un premier milieu (contenant la couche active) optiquement linéaire, homogène et isotrope, de constante diélectrique $\varepsilon_1$ et espacé d'un deuxième milieu optiquement linéaire, homogène et isotrope de constante diélectrique $\varepsilon_2$. Il présente ici une orientation inclinée d'un angle θ vis-à-vis de l'axe Z orthogonal au plan XY de la couche active. Les lignes de champ s'étendent suivant une symétrie axiale autour de l'axe du moment dipolaire **μ**. Le vecteur d'onde k est orthogonal à la tangente en un point quelconque d'une ligne de champ. Comme l'indique l'article de Schmidt et al intitulé Emitter Orientation as a Key Parameter in Organic Light-Emitting Diodes, Phys. Rev. Applied 8,037001 (2017), l'orientation des dipôles émetteurs est un paramètre qui peut impacter le rendement lumineux d'une diode émissive telle qu'une diode électroluminescente organique.

US 2014/008676 A1, US 2012/153254 A1, EP 1 855 327 A2 et EP 2 362 448 A1 divulguent des procédés de fabrication de diodes électroluminescentes connus de l'art antérieur.

Il existe ainsi un besoin de disposer d'un procédé de fabrication d'au moins une diode électroluminescente dont le rendement lumineux est amélioré.

**EXPOSÉ DE L'INVENTION**

L'invention a pour objectif de remédier au moins en partie aux inconvénients de l'art antérieur, et plus particulièrement de proposer un procédé de fabrication d'au moins une diode électroluminescente présentant un rendement lumineux amélioré.

Pour cela, l'objet de l'invention est un procédé de fabrication d'au moins une diode électroluminescente comportant : un empilement semiconducteur formé d'une première couche semiconductrice, d'une deuxième couche semiconductrice, et d'une couche active située entre les deux couches semiconductrices; et une couche d'extraction, réalisée en un matériau diélectrique transparent comportant des particules nanométriques, s'étendant au contact de la première couche semiconductrice. Le procédé comporte les étapes suivantes :

- choix des matériaux de la première couche semiconductrice et de la couche active, ainsi que de la couche d'extraction ;
- détermination d'une première distance non nulle entre, d'une part, des dipôles dits émetteurs associés aux recombinaisons radiatives de paires électron-trou dans la couche active, et d'autre part, la couche d'extraction, pour laquelle :

o une durée de vie des dipôles émetteurs, présentant une orientation dite verticale suivant un axe orthogonal au plan de la couche active, est supérieure à la durée de vie des dipôles émetteurs présentant une orientation dite horizontale suivant un axe parallèle au plan de la couche active, à partir d'une fonction prédéterminée exprimant une évolution d'un paramètre représentatif de la durée de vie d'un dipôle émetteur présentant une orientation prédéfinie en fonction de sa distance à la couche d'extraction, compte tenu des propriétés optiques desdits matériaux choisis ;

o des dipôles optiques associés aux particules nanométriques sont situés en champ proche des dipôles émetteurs, de manière à autoriser un couplage non radiatif de type dipôle-dipôle entre les dipôles émetteurs et les dipôles optiques ;

- réalisation de la diode électroluminescente, une épaisseur de la première couche semiconductrice étant telle que les dipôles émetteurs sont situés à la première distance déterminée vis-à-vis de la couche d'extraction, les dipôles émetteurs étant alors orientés de manière orthogonale au plan de la couche active.

Certains aspects préférés mais non limitatifs de ce procédé sont les suivants.

Les particules nanométriques peuvent être des boîtes quantiques réalisés en des nanocristaux semiconducteurs, et/ou être réalisées en au moins un matériau métallique.

Les particules nanométriques peuvent présenter un diamètre moyen compris entre 0.2nm et 500nm.

Les particules nanométriques peuvent s'étendre dans un plan parallèle à la couche active, et être disposées à l'interface avec la première couche semiconductrice.

La première distance déterminée peut être inférieure ou égale à 50nm, optimisant ainsi le couplage non radiatif de type dipôle-dipôle entre les dipôles émetteurs et les dipôles optiques.

La première distance déterminée peut être définie suivant un axe orthogonal au plan de la couche active, à partir d'une interface entre la couche d'extraction et la première couche semiconductrice jusqu'à un plan passant par la moitié d'une épaisseur de la couche active.

La couche active peut comporter au moins une couche émissive de puits quantique, et une couche barrière située entre la première couche semiconductrice et la couche émissive, la distance déterminée étant définie suivant un axe orthogonal au plan de la couche active, entre d'une part l'interface entre la couche d'extraction et la première couche semiconductrice, et d'autre part un plan passant par la moitié de l'épaisseur de la couche émissive.

Le procédé peut comporter une étape de détermination d'une deuxième distance non nulle entre les dipôles optiques associés aux particules nanométriques et un milieu environnant s'étendant au contact d'une face supérieure de la couche d'extraction opposée à la première couche semiconductrice, comportant les sous-étapes suivantes :

- choix d'une orientation des dipôles optiques vis-à-vis d'un plan de la couche d'extraction, parmi : une orientation horizontale pour laquelle les dipôles optiques sont orientés de manière parallèle au plan de la couche d'extraction, et une orientation verticale pour laquelle les dipôles optiques sont orientés de manière orthogonale au plan de la couche d'extraction ;
- détermination de la deuxième distance entre les dipôles optiques et le milieu environnant, pour laquelle une durée de vie des dipôles optiques présentant l'orientation choisie est supérieure à celle des dipôles optiques présentant l'orientation non choisie, à partir d'une fonction prédéterminée exprimant une évolution d'un paramètre représentatif de la durée de vie d'un dipôle optique présentant une orientation prédéfinie en fonction de sa distance au milieu environnant, compte tenu des propriétés optiques de la couche d'extraction et du milieu environnant ;
- réalisation de la diode électroluminescente, une épaisseur du matériau diélectrique de la couche d'extraction étant telle que les dipôles optiques sont situés à la deuxième distance déterminée vis-à-vis du milieu environnant, les dipôles optiques étant alors orientés selon l'orientation choisie vis à vis du plan de la couche d'extraction.

L'étape de détermination de la deuxième distance peut comporter les sous-étapes suivantes :

- détermination, sur une gamme de distance prédéfinie, de l'évolution en fonction de la distance du paramètre représentatif de la durée de vie du dipôle optique présentant l'orientation choisie, et de l'évolution en fonction de la distance du paramètre représentatif de la durée de vie du dipôle optique présentant l'orientation non choisie ;
- détermination d'un paramètre dit d'écart représentatif d'un écart du paramètre représentatif de la durée de vie du dipôle optique présentant l'orientation choisie vis-à-vis du paramètre représentatif de la durée de vie du dipôle optique présentant l'orientation non choisie, sur ladite gamme de distance prédéfinie ;
- détermination d'une distance non nulle de sorte que :

o le paramètre représentatif de la durée de vie du dipôle optique présentant l'orientation choisie est supérieur, pour la distance déterminée, à celui du paramètre représentatif de la durée de vie du dipôle optique présentant l'orientation non choisie, et que

o le paramètre d'écart présente, pour la distance déterminée, une valeur maximale sur au moins une partie de la gamme de distance.

Le procédé peut comporter :

- une étape de détermination d'une troisième distance non nulle entre les dipôles émetteurs et une électrode réflectrice s'étendant au contact de la deuxième couche semiconductrice, pour laquelle une durée de vie des dipôles émetteurs présentant l'orientation verticale est supérieure à celle des dipôles émetteurs présentant l'orientation horizontale, à partir d'une fonction prédéterminée exprimant une évolution d'un paramètre représentatif de la durée de vie d'un dipôle émetteur présentant une orientation prédéfinie en fonction de sa distance à l'électrode réflectrice, compte tenu des propriétés optiques de la couche active et de la deuxième couche semiconductrice, et de l'électrode réflectrice ;
- réalisation de la diode électroluminescente, une épaisseur de la deuxième couche semiconductrice étant telle que les dipôles émetteurs sont situés à la troisième distance déterminée vis-à-vis d'électrode réflectrice, les dipôles émetteurs étant alors orientés de manière orthogonale au plan de la couche active.

L'électrode réflectrice peut être une anode adaptée à injecter des trous dans l'empilement semiconducteur, et la deuxième couche semiconductrice peut être réalisée en un matériau cristallin semiconducteur dopé de type P, ou être réalisée en un matériau semiconducteur organique conducteur de trous.

La première couche semiconductrice peut être réalisée en un matériau cristallin semiconducteur dopé de type N, ou être réalisée en un matériau semiconducteur organique conducteur d'électrons.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

la figure 1A, déjà décrite, est une vue en coupe, schématique et partielle, d'une diode électroluminescente selon un exemple de l'art antérieur ;

la figure 1B, déjà décrite, illustre schématiquement un dipôle émetteur $\mu$ dans un premier milieu homogène et situé à une distance h d'un deuxième milieu homogène, émettant un rayonnement lumineux correspondant à une recombinaison radiative d'une paire électron-trou ;

la figure 2A est une vue en coupe, schématique et partielle, d'une diode électroluminescente comportant une couche d'extraction, obtenue selon un procédé de fabrication selon un mode de réalisation, illustrant des dipôles émetteurs $\mu_1$ dits donneurs situés dans une couche active et disposés à une distance $h_1$ de la couche d'extraction, ainsi que des dipôles optiques $\mu_2$ dits accepteurs situés dans la couche d'extraction ;

la figure 2B illustre un exemple d'évolution, en fonction de la distance $h_1$, de la durée de vie normalisée $\tau_{n1,v}$ d'un dipôle émetteur $\mu_1$ d'orientation verticale et celle $\tau_{n1,h}$ d'un dipôle émetteur $\mu_1$ d'orientation horizontale, dans le cas où le premier milieu homogène (première couche et couche active) est réalisé à base de GaN, et où le deuxième milieu homogène (couche d'extraction) est réalisé à base d'un matériau diélectrique, pour une longueur d'onde d'émission $\lambda_e$ égale à 460nm ;

la figure 3A est une vue en coupe, schématique et partielle, de la diode électroluminescente déjà illustrée sur la fig.2A, illustrant les dipôles optiques $\mu_2$ situés dans la couche d'extraction et disposés à une distance $h_2$ du milieu environnant surplombant la couche d'extraction ;

la figure 3B illustre un exemple d'évolution, en fonction de la distance $h_2$, de la durée de vie normalisée $\tau_{n2,v}$ d'un dipôle optique $\mu_2$ d'orientation verticale et celle $\tau_{n2,h}$ d'un dipôle optique $\mu_2$ d'orientation horizontale, dans le cas où le deuxième milieu homogène (couche d'extraction) est réalisé à base d'un matériau diélectrique, et où un troisième milieu homogène (milieu environnant) est de l'air, pour une longueur d'onde d'émission égale à 620nm ;

la figure 4 illustre un organigramme de différentes étapes d'un procédé de fabrication d'une diode électroluminescente selon un mode de réalisation ;

la figure 5A est une vue en coupe, schématique et partielle, de la diode électroluminescente déjà illustrée sur la fig.2A, illustrant les dipôles émetteurs $\mu_1$ situés dans la couche active et disposés à une distance $h_{1'}$ d'une électrode réflectrice (anode) ;

la figure 5B illustre un exemple d'évolution, en fonction de la distance $h_{1'}$, de la durée de vie normalisée $\tau_{n1',v}$ d'un dipôle émetteur $\mu_1$ d'orientation verticale et celle $\tau_{n1',h}$ d'un dipôle émetteur $\mu_1$ d'orientation horizontale, dans le cas où le premier milieu homogène (deuxième couche et couche active) est réalisé à base de GaN, et où un quatrième milieu homogène (électrode réflectrice) est réalisé en or, pour une longueur d'onde d'émission $\lambda_e$ égale à 460nm.

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'au moins une diode électroluminescente présentant un rendement lumineux amélioré. Le rendement lumineux est défini ici comme le rapport du flux lumineux émis par la diode électroluminescente sur la puissance électrique injectée, et correspond à l'efficacité quantique externe (EQE). Il est égal au produit du rendement quantique interne (IQE) et de l'efficacité d'extraction lumineuse. Le rendement quantique interne est le rapport du nombre de photons générés par recombinaison radiative sur le nombre d'électrons injectés par la cathode, et l'efficacité d'extraction lumineuse est le rapport du nombre de photons émis hors de la diode sur le nombre de photons générés.

Pour cela, une première couche de l'empilement semiconducteur de la diode électroluminescente est revêtue au moins en partie par une couche d'extraction destinée notamment à augmenter l'efficacité d'extraction lumineuse. Cette couche d'extraction est formée d'au moins un matériau diélectrique et transparent au rayonnement lumineux émis par la couche active de la diode électroluminescente. Elle comporte également, situées dans le matériau diélectrique, des particules nanométriques de type boîtes quantiques et/ou particules métalliques, de sorte que l'extraction lumineuse induit un couplage en champ proche de type dipôle-dipôle entre les dipôles optiques dits donneurs associés à la couche active et les dipôles optiques dits accepteurs associés aux particules nanométriques.

De plus, comme explicité en détail par la suite, on dimensionne la première couche semiconductrice de sorte que les dipôles optiques donneurs associés aux recombinaisons radiatives des paires électron-trou dans la couche active présentent une orientation verticale prédominante sur une orientation horizontale. Le caractère horizontal ou vertical de l'orientation du dipôle optique est relatif à un plan suivant lequel s'étend la couche active de la diode électroluminescente. Par ailleurs, l'orientation d'un dipôle émetteur correspond à l'angle d'inclinaison $\theta$ que forme le moment dipolaire $\mu$ du dipôle optique vis-à-vis d'un axe orthogonal au plan de la couche active.

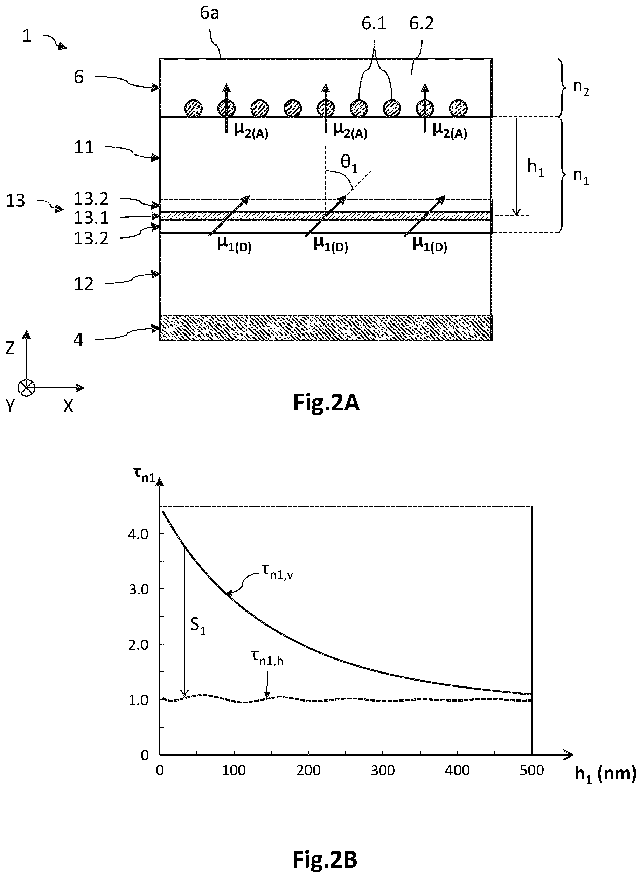

La figure 2A est une vue en coupe, schématique et partielle, d'un exemple de diode électroluminescente 1. Cette diode électroluminescente 1 est similaire à celle décrite précédemment, et en diffère essentiellement en ce qu'elle comporte une couche d'extraction 6 et a été obtenue par un procédé de fabrication selon un mode de réalisation.

On définit ici et pour la suite de la description un repère direct orthogonal XYZ, où les axes X et Y forment un plan parallèle au plan principal d'un substrat (non représenté) sur lequel repose la diode électroluminescente 1, et où l'axe Z est orienté de manière orthogonale au plan XY et en direction de la couche d'extraction 6. Ici, la couche active 13 s'étend suivant le plan XY.

La diode électroluminescente 1 comporte ainsi un empilement semiconducteur formé d'une première couche 11, d'une couche active 13, et d'une deuxième couche 12. Dans cet exemple, l'empilement semiconducteur est réalisé à base d'un matériau semiconducteur cristallin inorganique, mais en variante, il peut être réalisé à base d'un matériau semiconducteur organique (OLED). La diode électroluminescente 1 peut comporter des couches supplémentaires non représentées, par exemple une couche de blocage d'électrons, une couche tampon d'adaptation du paramètre de maille, etc...

Par « réalisé à base de matériau semiconducteur », on entend que l'empilement semiconducteur est réalisé en ce matériau semiconducteur ou en un ou plusieurs composés comportant ce matériau semiconducteur. A titre d'exemple, l'empilement semiconducteur est réalisé à base d'un composé III-V, par exemple à base de GaN, et peut ainsi comporter au moins une couche semiconductrice en GaN dopé ou non, et au moins une couche semiconductrice en un composé comportant du GaN, par exemple en InGaN, AlGaN, InAlGaN, voire est réalisé à base d'InP, par exemple du type AlInGaP, etc.

Notons comme indiqué précédemment que la diode électroluminescente 1 peut être une diode organique, auquel cas elle est formée de deux électrodes anodique et cathodique entre lesquelles sont empilées des couches semiconductrices organiques, dont une couche de transport d'électrons (ETL), une couche active (EML) et une couche de transport de trous (HTL).

Dans cet exemple où la diode électroluminescente 1 est réalisée à base d'un matériau inorganique, l'empilement semiconducteur est réalisé à base de GaN, la première couche 11 est en GaN dopé N, la deuxième couche 12 est en GaN dopé P. La couche active 13 comporte ici une couche 13.1 de puits quantique en InGaN intrinsèque située entre deux couches barrières 13.2 en GaN intrinsèque. Bien entendu, la couche active 13 peut comporter plusieurs couches de puits quantique situées entre deux couches barrières. L'électrode réflectrice 4 est réalisée en un ou plusieurs matériaux métalliques choisis parmi l'argent, l'aluminium, le cuivre, le titane, l'or, le nickel, l'iridium, le tungstène, l'indium, entre autres. Elle s'étend au contact de la deuxième couche 12. Elle est dite réflectrice dans la mesure où son coefficient de réflexion est au moins égal à 75%, au moins égal à 85%, voire à 95%, voire encore davantage, à la longueur d'onde d'émission de la diode électroluminescente 1. La couche active 13 s'étend suivant un plan XY parallèle à celui de la couche d'extraction 6. Une électrode cathodique (non représentée) peut s'étendre au contact de la première couche 11, par exemple de manière coplanaire à la couche d'extraction 6.

La couche d'extraction 6 est adaptée à permettre un couplage non radiatif en champ proche de type dipôle-dipôle avec la couche active 13, améliorant ainsi l'efficacité d'extraction lumineuse et donc les performances de la diode électroluminescente 1. Elle s'étend au contact de la première couche 11 (ici réalisée en GaN dopé N) et la revêt au moins partiellement (notamment lorsqu'une autre partie de la surface de la première couche 11 est revêtue par l'électrode cathodique).

La couche d'extraction 6 est formée d'un matériau diélectrique 6.2 et transparent à la longueur d'onde d'émission de la couche active 13 qui forme une matrice liante dans laquelle sont situés des particules nanométriques 6.1. Le matériau diélectrique transparent 6.2 présente un coefficient de transmission du rayonnement incident au moins égal à 50%, de préférence au moins égal à 75%, voire à 90%, voire davantage. Il peut être choisi parmi le silicone, le polysiloxane, les PDMS, le PMMA, le PVA, les couches minérales à base d'oxyde de type sol-gel tel que le $SiO_2$, $Al_2O_3$, ZnO, $TiO_2$, entre autres.

Les particules nanométriques 6.1 présentent un diamètre moyen de l'ordre de quelques nanomètres à quelques centaines de nanomètres, par exemple sont comprises entre 0.2nm et 500nm, et de préférence entre 2nm et 150nm. Elles peuvent notamment être des particules métalliques et/ou des boîtes quantiques. Les particules sont des éléments distincts les uns des autres, dont la forme peut être quelconque, par exemple sphérique, anguleuse, aplatie ou allongée, ou toute autre forme. La taille des particules est ici la plus petite dimension des particules et le diamètre moyen est la moyenne arithmétique de la taille des particules.

Dans le cas où les particules nanométriques 6.1 sont réalisées en un matériau métallique, celui-ci peut être choisi parmi Ag, Cu, Au, Pt, Pd, Ni, Co, Rh, In, Ru, Fe, CuNi, entre autres, et parmi les composés formés d'un mélange d'au moins deux ou plus de ces matériaux. La densité surfacique de particules métalliques est déterminée par la théorie de Mie de manière à optimiser l'efficacité d'absorption d'une particule métallique en fonction de l'indice de réfraction du milieu diélectrique. A titre d'exemple, pour un milieu diélectrique d'indice de réfraction de 1.5, un diamètre moyen de 55nm pour des particules nanométriques d'argent permet d'optimiser l'efficacité d'absorption à 460nm. La section efficace d'absorption de ces particules est alors de $0.5 \times 10^{-14} m^2$ et la densité surfacique peut alors être de l'ordre de $2 \times 10^{14} m^{-2}$.

Dans le cas où les particules nanométriques 6.1 sont des boîtes quantiques, celles-ci peuvent être réalisées sous la forme de nanocristaux semiconducteurs, dont la taille moyenne peut être comprise entre 0.2nm et 500nm, par exemple entre 1nm et 100nm, et notamment entre 2nm et 30nm. Le matériau semiconducteur des nanocristaux peut être notamment choisi parmi le séléniure de cadmium (CdSe), le phosphore d'indium (InP), le sulfure de cadmium (CdS), le sulfure de zinc (ZnS), l'oxyde de cadmium (CdO), le séléniure de zinc et de cadmium (CdZnSe), ou parmi d'autres matériaux semiconducteurs pouvant convenir. La densité surfacique dépend ici notamment du taux de conversion de lumière désiré, c'est-à-dire du rapport entre l'intensité du rayonnement de photoluminescence émis par les boîtes quantiques 6.1 sur l'intensité du rayonnement d'électroluminescence émis par la couche active 13.

Les particules nanométriques 6.1 peuvent également être des boîtes quantiques à effet plasmon, réalisées par exemple d'un cœur métallique entouré d'une gaine diélectrique, elle-même entourée d'une couche formant une boîte quantique. Le cœur métallique, par exemple en argent, forme une antenne absorbante pour le couplage dipôle-dipôle, et couple cette énergie absorbée au matériau formant la boîte quantique, qui va ensuite émettre un rayonnement de photoluminescence.

Les particules nanométriques 6.1 sont disposées dans la couche d'extraction 6 de préférence à proximité ou au niveau de l'interface avec la première couche 11, de manière à permettre le couplage non radiatif en champ proche entre les dipôles optiques $\mu_1$ associés à la couche active 13 et les dipôles optiques $\mu_2$ associés aux particules nanométriques 6.1. Elles sont de préférence disposées suivant un plan parallèle au plan XY. De préférence, la distance suivant l'axe Z séparant les particules nanométriques 6.1 de la couche active 13 est inférieure ou égale à 50nm. Cette distance peut être définie entre le plan dans lequel s'étendent majoritairement les particules nanométriques 6.1 et un plan passant par la moitié de l'épaisseur de la couche active 13.

**EP 3 843 162 B1**

La couche active 13 étant le lieu principal de la recombinaison radiative des paires électron-trou, les dipôles optiques $\mu_1$ dits émetteurs (appelés également donneurs $\mu_{1(D)}$ dans le cadre du couplage dipôle-dipôle) sont situés dans la couche active 13, et sont donc espacés d'une distance $h_1$ vis-à-vis de la couche d'extraction 6. On considère qu'ils sont situés dans un plan parallèle au plan XY et espacé de la distance $h_1$ de la couche d'extraction 6. On note $h_1=0$ l'interface entre la couche d'extraction 6 et la première couche 11.

La distance $h_1$ séparant les dipôles émetteurs $\mu_1$ vis-à-vis la couche d'extraction 6 est définie pour la suite de la description comme étant la distance suivant l'axe Z entre, d'une part, un plan passant par la moitié de l'épaisseur de la couche active 13, et d'autre part, la couche d'extraction 6. Cependant, en variante, et notamment lorsque la couche active 13 comporte plusieurs couches émissives 13.1 de puits quantique, on peut définir la distance $h_1$ comme étant la distance suivant l'axe Z entre, d'une part, un plan passant par la moitié de l'épaisseur de la couche 13.1 de puits quantique située au plus près de couche 12 en GaN-P, et d'autre part la couche d'extraction 6. Une étude préalable peut être effectuée pour déterminée où se situe précisément dans la couche active 13 l'essentiel des recombinaisons radiatives des paires électron-trou. Dans cet exemple, la distance $h_1$ est donc égale à la somme de l'épaisseur de la première couche 11, de l'épaisseur de la couche barrière 13.2, et de la moitié de l'épaisseur de la couche émissive 13.1.

L'orientation d'un dipôle émetteur $\mu_1$ correspond à l'angle $\theta_1$ entre son moment dipolaire et l'axe Z orthogonal au plan XY de la couche active 13. Aussi, un angle $\theta_1$ égal à 0° correspond à une orientation verticale des dipôles émetteurs $\mu_1$ vis-à-vis du plan de la couche active 13 et ici en direction de la couche d'extraction 6, et un angle $\theta_1$ égal à 90° correspond à une orientation horizontale.

On considère ici que les dipôles émetteurs $\mu_1$ sont situés dans un premier milieu optiquement linéaire homogène et isotrope de constante diélectrique $\varepsilon_1$ (permittivité relative) et d'indice de réfraction $n_1$, ce premier milieu étant formé de la couche active 13 et de la première couche 11. Par optiquement homogène, on entend que la constante diélectrique $\varepsilon_1$ est sensiblement constante en tout point de ce premier milieu, à 10% près, voire à 5% près, voire moins.

Le matériau diélectrique 6.2 de la couche d'extraction 6 forme un deuxième milieu que l'on considère, en première approximation comme étant optiquement linéaire homogène et isotrope, de constante diélectrique $\varepsilon_2$ et d'indice de réfraction $n_2$. Par extension, on considère que la couche d'extraction 6 forme ce même deuxième milieu homogène. L'indice de réfraction peut être l'indice optique ayant une partie réelle (indice de réfraction proprement dit) et une partie imaginaire non nulle (indice d'extinction).

Le procédé de fabrication d'une diode électroluminescente 1 comporte une phase de détermination d'une distance notée $h_{1s}$ entre les dipôles émetteurs $\mu_1$ associés aux recombinaisons radiatives dans la couche active 13 et la couche d'extraction 6, de sorte que les dipôles émetteurs $\mu_1$ présentent une orientation verticale ($\theta_1=0°$). L'épaisseur de la première couche 11 peut ensuite être déterminée en tenant compte de la valeur $h_{1s}$.

Pour cela, une fonction g est prédéterminée qui exprime une évolution, en fonction de la distance $h_1$, d'un paramètre représentatif d'une durée de vie d'un dipôle émetteur $\mu_1$ présentant l'une ou l'autre desdites orientations, en fonction des propriétés optiques $n_1$, $n_2$ des premier et deuxième milieux homogènes. Ainsi, la fonction g est notée $g_h$ ou $g_v$ lorsqu'elle est relative à une orientation horizontale ($\theta_1=90°$) ou verticale ($\theta_1=0°$).

La durée de vie $\tau$ est définie comme étant celle d'un dipôle émetteur situé dans un milieu optiquement linéaire, homogène et isotrope, de constante diélectrique $\varepsilon$. Elle correspond à la durée de vie de l'émission spontanée d'un système à deux niveaux, dont on considère en première approximation qu'elle est identique à la durée de vie des dipôles émetteurs dans le cadre de l'électroluminescence. On note $\tau_n$ la durée de vie normalisée égale au rapport de la durée de vie $\tau/\tau_0$, où la durée de vie $\tau_0$ est définie comme étant celle d'un dipôle émetteur situé dans le même milieu mais de dimensions infinies, donc à une distance infinie du deuxième milieu homogène.

Or, la durée de vie normalisée $\tau_n$ est égale à l'inverse de la puissance rayonnée normalisée P/Po du dipôle émetteur, autrement dit : $\tau_n = \tau/\tau_0 = P_0/P$. Ici, P est le taux de dissipation d'énergie du dipôle émetteur, autrement dit la puissance optique rayonnée par le dipôle émetteur dans le premier milieu homogène et situé à une distance h du deuxième milieu homogène, et Po est la puissance optique rayonnée par le même dipôle émetteur dans le premier milieu homogène de dimensions infinies (loin du deuxième milieu homogène, par exemple à plus 500nm du deuxième milieu homogène).

L'ouvrage de Novotny & Hecht intitulé Principles of Nano-Optics, Cambridge University Press, 2006, indique en page 344 (équation n°10.26) une expression de la puissance optique rayonnée normalisée P/Po d'un dipôle émetteur situé dans un premier milieu homogène à une distance h d'un substrat formé d'un deuxième milieu homogène (couche mince) et d'un troisième milieu homogène.

Cette équation peut être adaptée à notre configuration d'une diode électroluminescente 1 où le dipôle émetteur de la couche active 13 est situé dans le premier milieu homogène formé de la couche active 13 et de la première couche 11, et est disposé à une distance h du deuxième milieu homogène formé de la couche d'extraction 6. Ainsi, la puissance optique rayonnée normalisée par un tel dipôle émetteur peut s'écrire :

$$\frac{P}{P_0} = 1 + \frac{3}{4}\frac{\mu_x^2 + \mu_y^2}{\mu^2}\int_0^\infty Re\left(\frac{s}{s_z}[r^s - s_z^2 r^p]e^{2ik_1 h s_z}\right)ds + \frac{3}{2}\frac{\mu_z^2}{\mu^2}\int_0^\infty Re\left(\frac{s^3}{s_z}r^p e^{2ik_1 h s_z}\right)ds$$

où :

- $\mu$ est la norme du moment dipolaire, et $n_{x,y,z}$ est la coordonnée cartésienne du moment dipolaire suivant l'axe x, y ou z ;
- s est la variable d'intégration définie par s = $k_\rho/k_1$, avec :

  ○ $k_\rho$ la projection du vecteur d'onde **k** dans le plan XY, de sorte que $k_\rho = k_x/\cos\phi$ et $k_\rho = k_y/\sin\phi$ ; et $k_1$ est la norme du vecteur d'onde k dans le milieu 1 ;
  ○ $s_z$ égal à $(1-s^2)^{1/2}$ ;

- $r^s$ et $r^p$ sont les coefficients de réflexion du rayonnement optique émis par le dipôle émetteur pour les polarisations s et p à l'interface entre la première couche 11 et la couche d'extraction 6. Ces coefficients dépendent de la variable d'intégration s et leurs expressions générales sont données par les équations 10.20 et 10.21 en p.342 de Novotny & Hecht 2006.

Cependant, dans la configuration selon l'invention, le coefficient de réflexion $r^p$ à l'interface avec la couche d'extraction 6 pour le rayonnement lumineux de polarisation p peut s'écrire, en fonction de la variable d'intégration s, de la manière suivante :

$$r^p = \frac{\tan\left[\tan^{-1}\left(\frac{s}{s_z}\right) - \sin^{-1}\left(\frac{n_1}{n_2}\sin\left(\tan^{-1}\left(\frac{s}{s_z}\right)\right)\right)\right]}{\tan\left[\tan^{-1}\left(\frac{s}{s_z}\right) + \sin^{-1}\left(\frac{n_1}{n_2}\sin\left(\tan^{-1}\left(\frac{s}{s_z}\right)\right)\right)\right]}$$

Et le coefficient de réflexion $r^s$ à l'interface avec la couche d'extraction 6 pour le rayonnement lumineux de polarisation s peut s'écrire, en fonction de la variable d'intégration s, de la manière suivante :

$$r^s = -\frac{\sin\left[\tan^{-1}\left(\frac{s}{s_z}\right) - \sin^{-1}\left(\frac{n_1}{n_2}\sin\left(\tan^{-1}\left(\frac{s}{s_z}\right)\right)\right)\right]}{\sin\left[\tan^{-1}\left(\frac{s}{s_z}\right) + \sin^{-1}\left(\frac{n_1}{n_2}\sin\left(\tan^{-1}\left(\frac{s}{s_z}\right)\right)\right)\right]}$$

Par ailleurs, le terme $\mu_z^2/\mu^2$ correspond à $\cos\theta$, et le terme $(\mu_x^2 + \mu_y^2)/\mu^2$ est égal à $\sin\theta$. Le vecteur d'onde k présente, dans le premier milieu homogène, une norme notée $k_1$ égale à $2\pi/(n_1 \times \lambda)$. Comme mentionné précédemment, $n_1$ et $n_2$ sont les indices de réfraction des premier et deuxième milieux homogènes, lesquels sont déduits des constantes diélectriques $\varepsilon_1$, $\varepsilon_2$.

Ainsi, la puissance rayonnée P par le dipôle émetteur est formée de trois termes principaux, à savoir la puissance rayonnée intrinsèque $P_0$ (loin de tout phénomène lié à l'environnement du premier milieu homogène), un terme correspondant à la puissance rayonnée associée au moment dipolaire $\mu_x$ et $\mu_y$ dans le plan XY et un terme correspondant à la puissance rayonnée associée au moment dipolaire $\mu_z$ suivant l'axe Z.

Cette équation est obtenue à partir des équations de Maxwell, en utilisant les fonctions dyadiques de Green pour décrire un unique dipôle ponctuel oscillant, et la méthode de spectre angulaire du champ du dipôle vient étendre les fonctions de Green en ondes planes et évanescentes respectivement dans un système cylindrique. Le dipôle émetteur interagit donc avec ses propres ondes planes et évanescentes réfléchies.

Ainsi, on obtient une fonction g exprimant l'évolution d'un paramètre représentatif de la durée de vie d'un dipôle émetteur $\mu_1$ d'orientation $\theta_1$ prédéfinie en fonction de la distance $h_1$ à la couche d'extraction 6, compte tenu des propriétés optiques $n_1$ du premier milieu homogène (formé des première couche 11 et couche active 13) et de celles $n_2$ du deuxième milieu homogène (couche d'extraction 6). Le paramètre représentatif est de préférence la durée de vie normalisée $\tau_n = \tau/\tau_0$.

La figure 2B illustre un exemple d'évolutions, en fonction de la distance $h_1$, de la durée de vie normalisée $\tau_{n1,v}$ d'un dipôle émetteur $\mu_1$ d'orientation verticale et celle $\tau_{n1,h}$ d'un dipôle émetteur $\mu_1$ d'orientation horizontale, dans le cas où le premier milieu homogène est réalisé à base de GaN (première couche 11 et couche active 13), et le deuxième milieu homogène est réalisé en le matériau diélectrique 6.2 (couche d'extraction 6), pour une longueur d'onde d'émission égale à 460nm. Ces évolutions sont déterminées à partir de la fonction g décrite précédemment, et sont données sur une gamme de distance $\Delta h_{1ref}$ prédéfinie allant ici de 0nm à 500nm.

Plus précisément, la diode électroluminescente 1 comporte une couche émissive 13.1 en InGaN (pas de couche barrière en GaN intrinsèque) et une première couche 11 en GaN dopé N qui forment ensemble le premier milieu homogène. L'indice de réfraction $n_1$ est égal à 2.4764 environ pour une longueur d'onde d'émission de $\lambda$=460nm. La première couche 11 est au contact de la couche d'extraction 6 réalisée en un matériau diélectrique qui forme le deuxième milieu homogène et présente un indice de réfraction $n_2$ égal ici à 1.5.

Il apparaît que la durée de vie normalisée $\tau_{n1,h}$ des dipôles émetteurs $\mu_1$ à orientation horizontale reste sensiblement constante et égale à 1.0, quelle que soit la valeur de la distance $h_1$ sur la gamme $\Delta h_{1ref}$. En revanche, la durée de vie normalisée $\tau_{n1,v}$ des dipôles émetteurs $\mu_1$ à orientation verticale diminue à mesure que la distance $h_1$ augmente, passant ici de 4.5 environ pour $h_1$=0nm à 1.0 autour de 500nm. Ainsi, sur toute la gamme $\Delta h_{1ref}$, l'orientation verticale des dipôles émetteurs $\mu_1$ restent prépondérante sur l'orientation horizontale. On peut donc dimensionner l'épaisseur de la première couche 11 de sorte que la distance $h_{1s}$ retenue entre les dipôles émetteurs de la couche active 13 à la couche d'extraction 6 soit comprise entre 1nm et 500nm environ.

Cependant, il est avantageux que la distance $h_{1s}$ soit déterminée de sorte qu'un écart entre la durée de vie normalisée $\tau_{n1,v}$ des dipôles émetteurs $\mu_1$ d'orientation verticale et la durée de vie normalisée $\tau_{n1,h}$ des dipôles émetteurs $\mu_1$ d'orientation horizontale soit important en valeur absolue. Aussi, on peut définir un paramètre dit d'écart $S_1$, appelé sélectivité, représentatif d'un écart entre la durée de vie normalisée $\tau_{n1,v}$ d'un dipôle émetteur $\mu_1$ ayant l'orientation verticale et la durée de vie normalisée $\tau_{n1,h}$ d'un dipôle émetteur $\mu_1$ ayant l'orientation horizontale. Cette sélectivité $S_1$ peut être définie comme étant la différence ou le rapport, en valeur absolue ou non, entre la durée de vie normalisée $\tau_{n1,v}$ d'un dipôle émetteur $\mu_1$ présentant l'orientation verticale et la durée de vie normalisée $\tau_{n1,h}$ d'un dipôle émetteur $\mu_1$ présentant l'orientation horizontale. Autrement dit, $S_1 = = \tau_{n1,v} - \tau_{n1,h}$ ou en variante $S_1 = \tau_{n1,v} / \tau_{n1,h}$. Par la suite, on utilise $S_1 = = \tau_{n1,v} - \tau_{n1,h}$.

Il apparaît que le paramètre $S_1$ présente une valeur supérieure ou égale à 2.0 pour $h_1$ inférieure ou égale à 100nm, et une valeur supérieure ou égale à 2.5 pour $h_1$ inférieure ou égale à 50nm environ. On peut donc dimensionner l'épaisseur de la première couche 11 de sorte que la distance $h_{1s}$ entre les dipôles émetteurs de la couche active 13 à la couche d'extraction 6 soit comprise entre 1nm et 50nm environ. De préférence, l'épaisseur de la première couche 11 pourra être choisie entre 1nm et 100nm, et de préférence entre 5nm et 10nm environ de manière à maximiser l'effet de champ proche. Par « champ proche », on entend que la distance entre les dipôles accepteurs et donneurs est inférieure ou égale à $\lambda$/5, voire inférieure ou égale à $\lambda$/10, où $\lambda$ est la longueur d'onde d'émission du rayonnement émis par la couche active, moyennant l'indice de réfraction du milieu, dans laquelle le champ électrique rayonné par le dipôle décroît en $1/r^3$.

Aussi, il est possible de déterminer une distance $h_{1s}$ pour laquelle la durée de vie normalisée $\tau_{n1,v}$ associée à l'orientation verticale des dipôles émetteurs $\mu_1$ est supérieure à la durée de vie normalisée $\tau_{n1,h}$ associée à l'orientation horizontale. Dans ce cas, les dipôles émetteurs $\mu_1$ présentant l'orientation verticale seront prépondérants sur ceux présentant l'orientation horizontale. La diode électroluminescente 1 peut alors être dimensionnée, en particulier l'épaisseur de la première couche 11, de sorte que les dipôles émetteurs $\mu_1$ soient situés à la distance $h_{s1}$ de la couche d'extraction 6.

Ainsi, un couplage non radiatif en champ proche de type dipôle-dipôle est présent entre les dipôles émetteurs notés ici $\mu_{1(D)}$ (pour Donneurs) associés aux recombinaisons radiatives dans la couche active 13 et les dipôles notés ici $\mu_{2(A)}$ (pour Accepteurs) associés aux particules nanométriques 6.1. Ces dipôles $\mu_{1(D)}$ et $\mu_{2(A)}$ sont les vecteurs des moments dipolaires des dipôles optiques. L'intensité de ce couplage non radiatif est caractérisée par le facteur angulaire de couplage $K^2$.

De manière connue, le facteur angulaire de couplage $K^2$ entre les dipôles émetteurs $\mu_{1(D)}$ et $\mu_{2(A)}$ est défini par la relation :

$$K^2 = \left( \boldsymbol{n_A} . \boldsymbol{n_D} - 3(\boldsymbol{n_A} . \boldsymbol{n_D})(\boldsymbol{n_r} . \boldsymbol{n_A}) \right)^2$$

Cette expression est notamment décrite dans l'ouvrage de Novotny & Hecht 2006 en page 290 (équation 8.169). Le facteur $K^2$ dépend de l'orientation des vecteurs unitaires $n_A$ et $\boldsymbol{n_D}$ associés aux dipôles accepteurs $\mu_{2(A)}$ et donneurs $\mu_{1(D)}$, et du vecteur unitaire $\boldsymbol{n_r}$ reliant les dipôles accepteurs $\mu_{2(A)}$ et donneurs $\mu_{1(D)}$ considérés.

L'interaction dipôle-dipôle modifie les propriétés d'absorption des dipôles accepteurs $\mu_{2(A)}$. Il y a un transfert d'énergie non-radiatif entre les dipôles donneurs $\mu_{1(D)}$ et les dipôles accepteurs $\mu_{2(A)}$, appelé couplage FRET (*Förster resonance energy transfer*, en anglais), qui se traduit par une augmentation du rendement lumineux de la diode électroluminescente 1.

Il apparaît que le facteur angulaire de couplage $K^2$ est maximal lorsque les dipôles donneurs $\mu_{1(D)}$ et accepteurs $\mu_{2(A)}$ sont colinéaires, auquel cas, le facteur $K^2$ est égal à 4. Ainsi, dimensionner la première couche 11 pour obtenir une orientation verticale prépondérante des dipôles donneurs $\mu_{1(D)}$ permet de rendre les dipôles accepteurs $\mu_{2(A)}$ colinéaires avec les dipôles donneurs $\mu_{1(D)}$, et ainsi d'améliorer encore le rendement lumineux de la diode électroluminescente 1. En effet, dans le cadre du couplage non radiatif dipôle-dipôle, les dipôles accepteurs $\mu_{2(A)}$ s'orientent suivant l'orientation des dipôles donneurs $\mu_{1(D)}$.

Dans le cas où la couche d'extraction 6 est formée de particules métalliques 6.1, le rendement lumineux de la diode électroluminescente 1 est augmenté de plus par une émission lumineuse supplémentaire par effet plasmonique. Les particules métalliques 6.1 peuvent ainsi émettre un rayonnement lumineux à une longueur d'onde de résonance sensiblement identique à la longueur d'onde d'électroluminescence $\lambda_e$ de la diode électroluminescente 1. Pour cela, des modes plasmoniques des particules métalliques 6.1 sont excités, dont un mode résonant peut conduire à l'émission du rayonnement lumineux supplémentaire. Ici, le mode résonant plasmonique des particules métalliques 6.1 correspond à des dipôles accepteurs $\mu_{2(A)}$ situés en champ proche des dipôles donneurs $\mu_{1(D)}$. Par ailleurs, dans le cas où les particules nanométriques 6.1 sont des boîtes quantiques, la couche d'extraction 6 assure une fonction supplémentaire de conversion de couleur, en convertissant une partie du rayonnement lumineux émis par la couche active 13 en un rayonnement lumineux de plus grande longueur d'onde.

Par ailleurs, il peut être avantageux de dimensionner l'épaisseur de la couche d'extraction 6 de sorte que les dipôles optiques $\mu_2$ associés aux particules nanométriques 6.1 soient situés à une distance $h_{2s}$ déterminée vis-à-vis de l'interface entre sa face supérieure 6a et le milieu environnant (par ex., de l'air). Il peut en effet être avantageux de rendre prépondérante l'orientation verticale de ces dipôles optiques $\mu_2$ de manière par exemple à optimiser davantage le couplage non radiatif en champ proche de type dipôle-dipôle avec les dipôles optiques $\mu_1$ de la couche active 13. Il peut au contraire être avantageux de rendre prépondérante l'orientation horizontale de ces dipôles optiques $\mu_2$ lorsque les particules nanométriques 6.1 forment des boîtes quantiques, de manière à optimiser l'intensité du rayonnement lumineux de photoluminescence en champ lointain. Les particules nanométriques 6.1 sont toujours situées à la distance $h_{1s}$ prédéterminée vis-à-vis de la couche active 13.

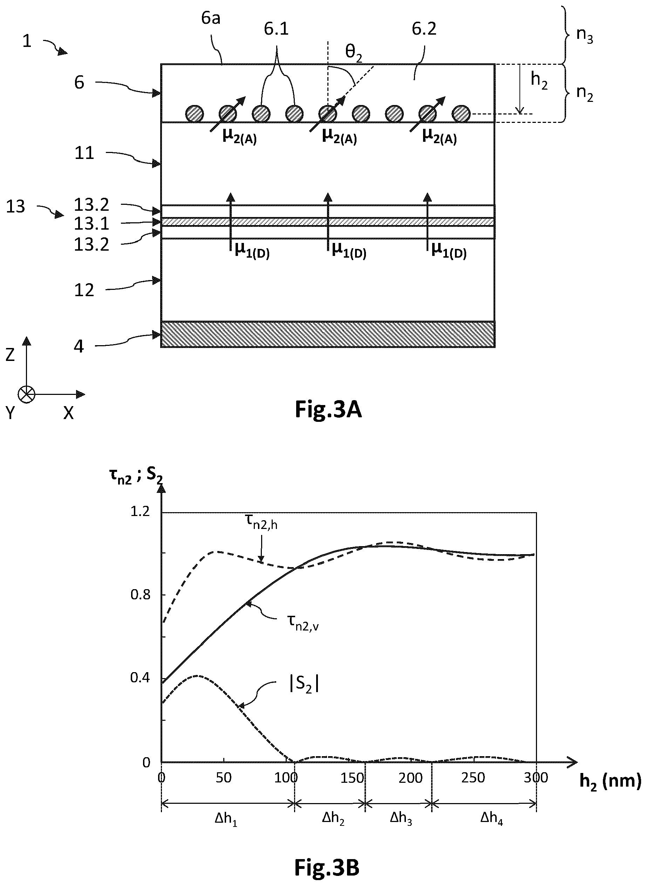

La figure 3A est une vue schématique et partielle de la diode électroluminescente illustrée sur la fig.2A. Les particules nanométriques 6.1 sont situées de préférence à l'interface avec la première couche 11, et sont disposées dans un plan XY, à la distance $h_{1s}$ des dipôles optiques $\mu_1$. Les dipôles dipolaires $\mu_2$ forment un angle $\theta_2$ avec l'axe Z, de sorte qu'ils présentent une orientation verticale dans le cas où $\theta_2=0°$, et une orientation horizontale dans le cas où $\theta_2=90°$. Ils sont disposés à une distance $h_2$ vis-à-vis de la face supérieure 6a. On considère ici que la couche d'extraction 6 forme un deuxième milieu optiquement linéaire, homogène et isotrope d'indice de réfraction $n_2$, et que le milieu environnant forme un troisième milieu optiquement linéaire, homogène et isotrope d'indice de réfraction $n_3$. La distance $h_2$ est mesurée à partir de la face supérieure 6a suivant la direction -Z. Aussi, une valeur $h_2$ nulle correspond à la face supérieure 6a. Dimensionner l'épaisseur de la couche d'extraction 6 revient à choisir l'épaisseur suivant l'axe Z du matériau diélectrique 6.2.

La figure 3B illustre un exemple d'évolutions, en fonction de la distance $h_2$, de la durée de vie normalisée $\tau_{n2,v}$ d'un dipôle émetteur $\mu_2$ d'orientation verticale et celle $\tau_{n2,h}$ d'un dipôle émetteur $\mu_2$ d'orientation horizontale, dans le cas où le deuxième milieu homogène est réalisé à base d'un matériau diélectrique d'indice de réfraction $n_2=1.5$, et où le troisième milieu homogène est de l'air, pour une longueur d'onde d'émission égale à 620nm. Les dipôles optiques $\mu_2$ sont ici associés à des boîtes quantiques 6.1 émettant dans le rouge. Cette figure illustre également l'évolution, en fonction de la distance $h_2$, d'un paramètre $S_2$ appelé sélectivité représentatif d'un écart entre ces deux durées de vie normalisées $\tau_{n2,v}$, $\tau_{n2,h}$.

Il apparaît que les durées de vie normalisées $\tau_{n2,v}$, $\tau_{n2,h}$ présentent une augmentation à partir de $h_2=0$nm jusqu'à 50nm environ pour $\tau_{n2,h}$ et jusqu'à 150nm environ pour $\tau_{n2,v}$. Ensuite, elles restent sensiblement constantes autour de 1.0 à mesure que $h_2$ augmente, tout en présentant des oscillations amorties.

Il apparaît toutefois que la durée de vie associée à l'une des orientations prédomine sur la durée de vie associée à l'autre orientation pour plusieurs domaines $\Delta h_{i=1,2...}$ de distance $h_2$ de la gamme $\Delta h_{2ref}$, et que cette prédominance alterne en fonction de la distance $h_2$.

Aussi, il est possible de déterminer une distance $h_{2s}$ pour laquelle la durée de vie normalisée $\tau_{n2,s}$ associée à l'orientation choisie (parmi les orientations verticale et horizontale) des dipôles émetteurs $\mu_2$ est supérieure à la durée de vie normalisée $\tau_{n,ns}$ associée à l'autre orientation non choisie. Dans ce cas, les dipôles émetteurs $\mu_2$ présentent l'orientation choisie seront prépondérants sur ceux présentant l'orientation non choisie. La diode électroluminescente 1 peut alors être dimensionnée, en particulier l'épaisseur du matériau diélectrique 6.2 de la couche d'extraction 6, de sorte que les dipôles émetteurs $\mu_2$ soient situés à la distance $h_{2s}$ de la face supérieure 6a, et présentent donc l'orientation choisie. Les dipôles émetteurs $\mu_2$ peuvent ainsi, de préférence, présenter une orientation horizontale lorsque les particules nanométriques 6.1 sont des boîtes quantiques, ou présenter une orientation verticale lorsque les particules nanométriques 6.1 sont métalliques pour un effet plasmonique.

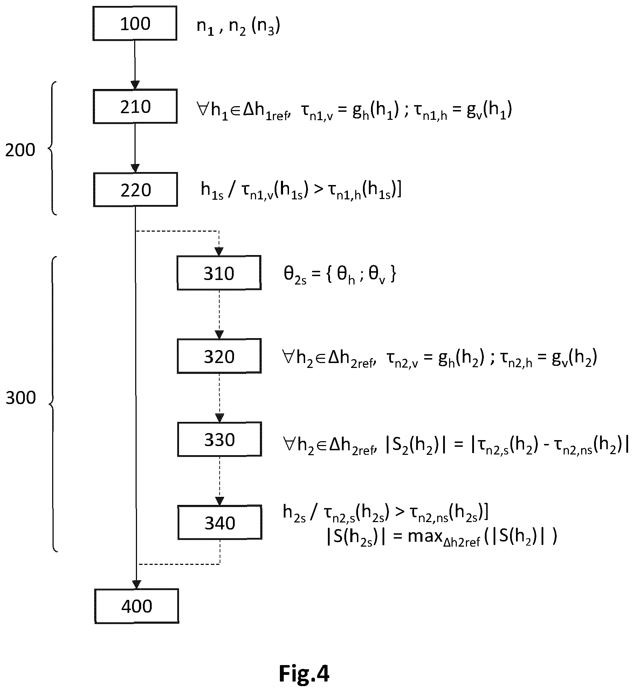

La figure 4 est un organigramme illustrant des étapes d'un procédé de fabrication d'une diode électroluminescente 1 selon un mode de réalisation. Le procédé de fabrication est ici illustré dans le cas d'une diode électroluminescente 1 comportant un empilement semiconducteur de type inorganique. Dans cet exemple, la première couche 11 est réalisée en GaN dopé N, et une couche active 13 est formée d'une couche émissive de puits quantique en InGaN. La couche d'extraction 6 est formée d'un matériau diélectrique 6.2 contenant des particules nanométriques 6.1.

Dans une étape 100, on choisit les matériaux de la première couche 11 et de la couche active 13 qui forment ensemble le premier milieu homogène d'indice de réfraction $n_1$. Il s'agit ici d'un GaN dopé N et d'InGaN, dont l'indice de réfraction est sensiblement égal pour ces deux matériaux et correspond à 2.4764 à la longueur d'onde d'émission de 460nm. Dans le cas où les indices de réfraction ne sont pas identiques, on peut définir un indice de réfraction moyen à partir par exemple d'une pondération volumique des indices de réfraction. On choisit également le matériau de la couche d'extraction 6 qui forme le deuxième milieu homogène d'indice de réfraction $n_2$ sensiblement égal à celui du matériau diélectrique 6.2.

Comme indiqué précédemment, la distance $h_1$ correspond ici à la distance suivant l'axe Z entre, d'une part l'interface couche d'extraction 6 / première couche 11, et d'autre part la moitié de l'épaisseur de la couche active 13. Dans cet exemple, la couche active 13 est une couche émissive 13.1 de puits quantique de 3nm d'épaisseur, et on cherche à déterminer l'épaisseur de la première couche 11 de sorte que les dipôles émetteurs $\mu_1$ (situés en première approximation au centre de la couche active 13) soient situés à la distance $h_{1s}$ déterminée pour obtenir une orientation dipolaire verticale.

Dans une étape 200, on détermine une valeur $h_{1s}$ de la distance $h_1$ de sorte qu'une durée de vie des dipôles émetteurs $\mu_1$ ayant l'orientation verticale $\theta_v$ soit supérieure à celle des dipôles émetteurs $\mu_1$ ayant l'orientation horizontale $\theta_h$. On utilise pour cela la fonction prédéterminée g exprimant une relation entre une durée de vie d'un dipôle optique ayant une orientation prédéfinie $\theta$ et la distance h. Cette fonction g est celle décrite précédemment, qui exprime l'évolution de la durée de vie normalisée $\tau_n$ d'un dipôle émetteur en fonction de la distance h, par le biais de la puissance optique rayonnée normalisée P/Po.

Dans une sous-étape 210, on détermine l'évolution $g_h$ en fonction de $h_1$ de la durée de vie normalisée $\tau_{n1,h}$ d'un dipôle émetteur $\mu_1$ d'orientation horizontale $\theta_h$, ainsi que l'évolution $g_v$ de la durée de vie normalisée $\tau_{n1,v}$ d'un dipôle émetteur $\mu_1$ d'orientation verticale $\theta_v$, sur une gamme de distance $\Delta h_{1ref}$ allant par exemple de 0nm à 500nm. Ces évolutions $g_h$ et $g_v$ sont déterminées à partir des relations $\tau_n = P_0/P$ et $P/P_0 = f(h)$ indiquées précédemment. On obtient ainsi $\tau_{n1,v} = g_v(h_1)$ et $\tau_{n1,h} = g_h(h_1)$ pour $h_1$ quelconque compris dans la gamme $\Delta h_{1ref}$.

Dans une sous-étape 220, on détermine une valeur $h_{1s}$ telle que la durée de vie normalisée $\tau_{n1,v}$ du dipôle émetteur $\mu_1$ d'orientation verticale $\theta_v$ est supérieure à la durée de vie normalisée $\tau_{n1,h}$ du dipôle émetteur $\mu_1$ d'orientation horizontale $\theta_h$, c'est-à-dire ici de sorte que $\tau_{n1,v}(h_{1s}) > \tau_{n1,h}(h_{1s})$. De plus, la valeur $h_{1s}$ est avantageusement déterminée de sorte que la sélectivité $|S_1(h_{1s})|$ est maximale sur au moins un domaine de la gamme $\Delta h_{1ref}$, et de préférence sur toute la gamme $\Delta h_{1ref}$, autrement dit $|S_1(h_{1s})| = max_{\Delta h1ref}(|S_1(h_1)|)$.

D'autres conditions peuvent être également prises en compte, comme par exemple le fait que la valeur $h_{1s}$ soit supérieure ou égale à une valeur minimale $h_{th}$ non nulle prédéfinie, par exemple pour optimiser la diffusion des porteurs de charge dans le plan XY au sein de la première couche 11 à partir de l'électrode cathodique 5 (illustrée sur la fig.1A).

Dans une étape 300 facultative mais avantageuse, on détermine également une valeur $h_{2s}$ de la distance $h_2$ de sorte qu'une durée de vie normalisée $\tau_{n2,s}$ des dipôles optiques $\mu_2$, ayant une orientation choisie $\theta_{2s}$ (parmi l'orientation horizontale $\theta_h$ et l'orientation verticale $\theta_v$), soit supérieure à la durée de vie normalisée $\tau_{n2,ns}$ des dipôles optiques $\mu_2$ ayant l'orientation non choisie $\theta_{ns}$.

Pour cela, dans une sous-étape 310, on choisit l'orientation souhaitée $\theta_{2s}$ des dipôles optiques $\mu_2$ associés aux particules nanométriques 6.1, c'est-à-dire ici l'angle $\theta_2$ que forme le moment dipolaire $\mu_2$ vis-à-vis de l'axe Z orthogonal, parmi l'orientation verticale $\theta_v$ ($\theta_2$=0°) et l'orientation horizontale $\theta_h$ ($\theta_2$=90°). Dans cet exemple, l'orientation choisie $\theta_{2s}$ est l'orientation horizontale $\theta_h$ ($\theta_{2s}$=90°).

Dans une sous-étape 320, on détermine l'évolution $g_h$ en fonction de $h_2$ de la durée de vie normalisée $\tau_{n2,h}$ d'un dipôle optique $\mu_2$ d'orientation horizontale $\theta_h$, ainsi que l'évolution $g_v$ de la durée de vie normalisée $\tau_{n2,v}$ d'un dipôle optique $\mu_2$ d'orientation verticale $\theta_v$, sur une gamme de distance $\Delta h_{2ref}$ allant par exemple de 0nm à 300nm.

Dans une sous-étape 330, on compare la durée de vie normalisée $\tau_{n2,h}$ du dipôle optique $\mu_2$ d'orientation choisie à la durée de vie normalisée $\tau_{n2,v}$ du dipôle optique $\mu_2$ d'orientation non choisie $\tau_{n,v}$ pour tout $h_2$ compris dans $\Delta h_{2ref}$. On détermine avantageusement le paramètre de sélectivité $S_2$ telle que, pour tout $h_2$ compris dans $\Delta h_{2ref}$, la valeur absolue $|S_2|$ de la sélectivité $S_2$ est égale à la valeur absolue de la différence entre la durée de vie normalisée $\tau_{n2,s}$ du dipôle optique $\mu_2$ d'orientation choisie et la durée de vie normalisée $\tau_{n2,ns}$ du dipôle optique $\mu_2$ d'orientation non choisie, c'est-à-dire ici : $|S_2(h_2)| = | \tau_{n2,s}(h_2) - \tau_{n2,ns}(h_2) |$.

Dans une sous-étape 340, on détermine alors une valeur $h_{2s}$ telle que la durée de vie normalisée $\tau_{n2,s}$ du dipôle optique $\mu_2$ d'orientation choisie $\theta_s$ est supérieure à la durée de vie normalisée $\tau_{n2,ns}$ du dipôle optique $\mu_2$ d'orientation non choisie $\theta_{ns}$, c'est-à-dire ici de sorte que $\tau_{n2,s}(h_{2s}) > \tau_{n2,ns}(h_{2s})$. De plus, la valeur $h_{2s}$ est avantageusement déterminée de sorte que la sélectivité $|S_2(h_{2s})|$ est maximale sur au moins un domaine de la gamme $\Delta h_{2ref}$, et de préférence sur toute la gamme $\Delta h_{2ref}$, autrement dit $|S_2(h_{2s})| = max_{\Delta h2ref}(|S_2(h_2)|)$.

Dans une étape 400, on fabrique la diode électroluminescente 1 de sorte que les dipôles émetteurs $\mu_1$ soient situés à la distance $h_{1s}$ de la couche d'extraction 6. Dans le cas où la couche active 13 présente des dimensions fixées, par exemple 3nm pour une couche de puits quantique et 12nm pour une couche barrière, on détermine l'épaisseur de la première couche 11 de sorte que la somme de cette épaisseur et de la moitié de la couche active 13 soit égale à la valeur déterminée $h_{1s}$, par exemple à 10nm près, voire à 5nm près.

Aussi, les dipôles émetteurs $\mu_1$ associés aux recombinaisons radiatives des paires électron-trou dans la couche active 13 présentent essentiellement l'orientation verticale $\theta_v$. On améliore ainsi le rendement lumineux de la diode électroluminescente 1 par un couplage non radiatif en champ proche de type dipôle-dipôle entre les dipôles émetteurs $\mu_1$ et les dipôles optiques $\mu_2$.

Par ailleurs, on détermine l'épaisseur de la couche d'extraction 6, en particulier l'épaisseur du matériau diélectrique 6.2, les particules nanométriques 6.1 restant avantageusement à l'interface avec la première couche 11, de sorte que les dipôles optiques $\mu_2$ soient situés à la distance $h_{2s}$ vis-à-vis de l'interface à l'air (face 6a), et présentent ainsi l'orientation choisie $\theta_{2s}$. Cela contribue également à améliorer le rendement lumineux de la diode électroluminescente 1.

Par ailleurs, le procédé de fabrication peut comporter une phase de dimensionnement de la deuxième couche 12 disposée entre la couche active 13 et l'électrode réflectrice 4 (anode). Ainsi, il est également avantageux de dimensionner cette couche 12 de sorte que les dipôles émetteurs $\mu_1$ présentent l'orientation verticale $\theta_{1v}$.

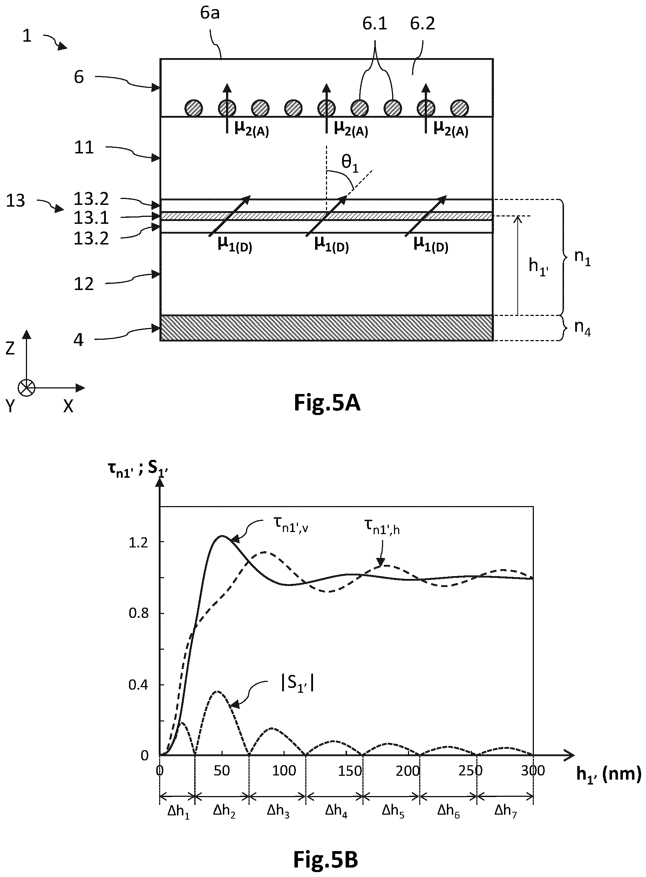

La figure 5A est une vue schématique et partielle de la diode électroluminescente illustrée sur la fig.2A. La deuxième couche 12 et la couche active 13 forme le même premier milieu homogène d'indice de réfraction $n_1$. Le quatrième milieu optiquement linéaire, homogène et isotrope, d'indice optique $n_4$ est formé par l'électrode réflectrice 4 d'indice de réfraction $n_4$. La couche active 13, et plus précisément les dipôles émetteurs $\mu_1$, sont disposés à une distance $h_{1'}$ vis-à-vis de l'électrode réflectrice 4. La distance $h_{1'}$ est mesurée à partir de l'électrode réflectrice 4 suivant la direction +Z. Aussi, une valeur $h_{1'}$ nulle correspond à l'interface entre la deuxième couche 12 et l'électrode réflectrice 4.

La figure 5B illustre un exemple d'évolutions, en fonction de la distance $h_{1'}$, de la durée de vie normalisée $\tau_{n1',v}$ d'un dipôle émetteur $\mu_1$ d'orientation verticale, et la durée de vie normalisée $\tau_{n1',h}$ d'un dipôle émetteur $\mu_1$ d'orientation horizontale. Elle illustre également l'évolution en fonction de $h_{1'}$ de la sélectivité $S_{1'}$.

Dans cet exemple, le premier milieu homogène d'indice de réfraction $n_1$ est formé de la deuxième couche 12 en GaN dopé P et d'une couche émissive en InGaN (pas de couche barrière en GaN intrinsèque). Le quatrième milieu homogène est formé par l'électrode réflectrice 4 réalisée ici en or, dont l'indice optique $n_4$ est égal à $1.3489 + i \times 1.8851$ à 460nm.

La durée de vie normalisée $\tau_{n1'}$ des dipôles émetteurs $\mu_1$ présentant une orientation horizontale ou verticale augmente à partir d'une valeur nulle pour $h_{1'}$ égal à zéro jusqu'à un premier pic, puis tend vers une même valeur constante en présentant des oscillations amorties. Les valeurs constantes sont sensiblement égales pour les deux orientations. Cependant, les oscillations n'étant pas en phase l'une avec l'autre, il existe des domaines $\Delta h_{i=1,2...}$ de la gamme $\Delta h_{1ref}$ pour lesquels la durée de vie normalisée associée à l'une des orientations est prépondérante sur la durée de vie normalisée associée à l'autre orientation. Il est alors possible de dimensionner la diode électroluminescente 1, en particulier de choisir une valeur de la distance $h_{1s'}$, de sorte que les dipôles émetteurs $\mu_1$ présentent de manière prépondérante l'orientation verticale.

Dans cet exemple, les dipôles émetteurs $\mu_1$ d'orientation verticale sont prépondérants dans les domaines $\Delta h_2$, $\Delta h_4$, $\Delta h_6$ de la gamme $\Delta h_{ref}$ allant de zéro à 300nm. Et les dipôles émetteurs $\mu_1$ d'orientation horizontale sont prépondérants dans les domaines $\Delta h_1$, $\Delta h_3$, $\Delta h_5$, $\Delta h_7$. Ainsi, une distance $h_{1s'}$ comprise dans le domaine $\Delta h_2$ ou $\Delta h_4$, par exemple, permettra d'obtenir des recombinaisons radiatives des paires électron-trou dont le rayonnement émis correspond à celui de dipôles émetteurs $\mu_1$ présentant une orientation essentiellement verticale.

Comme mentionné précédemment, pour obtenir une prépondérance des dipôles émetteurs $\mu_1$ ayant l'orientation choisie sur ceux ayant l'orientation non choisie, il importe que la durée de vie des dipôles émetteurs $\mu_1$ ayant l'orientation choisie soit supérieure à celle des dipôles émetteurs ayant l'autre orientation.

La sélectivité $S_{1'}$ s'annule ainsi entre chaque domaine $\Delta h_i$ et présente une valeur maximale pour chacune d'entre elles. A titre d'exemple, la sélectivité présente une valeur de 0.18 pour 18nm dans $\Delta h_1$ (orientation horizontale), une valeur de 0.36 pour 46nm dans $\Delta h_2$ (orientation verticale), une valeur de 0.15 pour 90nm dans $\Delta h_3$ (orientation horizontale), et une valeur de 0.08 pour 140nm dans $\Delta h_4$ (orientation verticale). Il apparaît donc que les différents domaines ne présentent pas une sélectivité $S_{1'}$ de même intensité, signe que les durées de vie normalisées évoluent en fonction de la distance $h_{1'}$ sous forme d'oscillations amorties.

Ainsi, pour améliorer le rendement lumineux d'une diode électroluminescente 1, il est possible de dimensionner celle-ci de sorte que les dipôles émetteurs $\mu_1$ présentent une orientation verticale. Pour cela, la distance $h_{1s'}$ est choisie dans l'un des domaines $\Delta h_i$ de la gamme $\Delta h_{1ref}$ pour lesquelles la durée de vie des dipôles émetteurs $\mu_1$ ayant l'orientation verticale est supérieure à celle des dipôles émetteurs $\mu_1$ ayant l'orientation horizontale. De plus, la distance $h_{1s'}$ est avantageusement déterminée de sorte que la sélectivité $S_{1'}$ présente un maximum dans la gamme de distance $\Delta h_{1ref}$ déterminée. Dans cet exemple, pour obtenir une prédominance des dipôles émetteurs $\mu_1$ d'orientation verticale, il est avantageux que la distance $h_{1s'}$ soit égale à 54nm dans la mesure où la sélectivité $S_{1'}$ présente un maximum égal à 0.38.

Des modes de réalisation particuliers viennent d'être décrits. Différentes variantes et modifications apparaîtront à l'homme du métier. La portée de l'invention est définie par les revendications.

**Revendications**

1. Procédé de fabrication d'au moins une diode électroluminescente (1) comportant :

   • un empilement semiconducteur formé d'une première couche semiconductrice (11), d'une deuxième couche semiconductrice (12), et d'une couche active (13) située entre les deux couches semiconductrices (11, 12), et
   • une couche d'extraction (6), réalisée en un matériau diélectrique transparent comportant des particules nanométriques (6.1), s'étendant au contact de la première couche semiconductrice (11),

      o le procédé comportant l'étape suivante :

         o choix (100) des matériaux de la première couche semiconductrice (11) et de la couche active (13), ainsi que de la couche d'extraction (6),

      le procédé étant **caractérisé en ce qu'**il comprend en outre les étapes suivantes :

         o détermination (200) d'une première distance ($h_{1s}$) non nulle entre, d'une part, des dipôles dits émetteurs ($\mu_1$) associés aux recombinaisons radiatives de paires électron-trou dans la couche active (13), et d'autre part, la couche d'extraction (6), pour laquelle :

      • une durée de vie ($\tau_{n,v}$) des dipôles émetteurs ($\mu_1$), présentant une orientation dite verticale ($\theta_v$) suivant un axe orthogonal au plan de la couche active (13), est supérieure à la durée de vie ($\tau_{n,h}$) des dipôles émetteurs ($\mu_1$) présentant une orientation dite horizontale ($\theta_h$) suivant un axe parallèle au plan de la couche active (13),

         - à partir d'une fonction prédéterminée ($g_{h,v}$) exprimant une évolution d'un paramètre représentatif de la durée de vie d'un dipôle émetteur ($\mu_1$) présentant une orientation prédéfinie ($\theta_h$ ; $\theta_v$) en fonction de sa distance ($h_1$) à la couche d'extraction (6), compte tenu des propriétés optiques ($n_1$, $n_2$) desdits matériaux choisis ;

      • des dipôles optiques ($\mu_2$) associés aux particules nanométriques (6.1) sont situés en champ proche des dipôles émetteurs ($\mu_1$), de manière à autoriser un couplage non radiatif de type dipôle-dipôle entre les dipôles émetteurs ($\mu_1$) et les dipôles optiques ($\mu_2$) ;

         o réalisation (400) de la diode électroluminescente (1), une épaisseur de la première couche semiconductrice (11) étant telle que les dipôles émetteurs ($\mu_1$) sont situés à la première distance déterminée ($h_{1s}$) vis-à-vis de la couche d'extraction (6), les dipôles émetteurs ($\mu_1$) étant alors orientés de manière orthogonale au plan de la couche active (13).

2. Procédé selon la revendication 1, dans lequel les particules nanométriques (6.1) sont des boîtes quantiques réalisés en des nanocristaux semiconducteurs, et/ou sont réalisées en au moins un matériau métallique.

3. Procédé selon la revendication 1 ou 2, dans lequel les particules nanométriques (6.1) présentent un diamètre moyen compris entre 0.2nm et 500nm.

4. Procédé selon l'une quelconque des revendications 1 à 3, dans lequel les particules nanométriques (6.1) s'étendent dans un plan parallèle à la couche active (13), et sont disposées à l'interface avec la première couche semiconductrice (11).

5. Procédé selon l'une quelconque des revendications 1 à 4, dans lequel la première distance déterminée ($h_{1s}$) est inférieure ou égale à 50nm, optimisant ainsi le couplage non radiatif de type dipôle-dipôle entre les dipôles émetteurs ($\mu_1$) et les dipôles optiques ($\mu_2$).

6. Procédé selon l'une quelconque des revendications 1 à 5, dans lequel la première distance déterminée ($h_{1s}$) est définie suivant un axe orthogonal au plan de la couche active (13), à partir d'une interface entre la couche d'extraction (6) et la première couche semiconductrice (11) jusqu'à un plan passant par la moitié d'une épaisseur de la couche

**13**

active (13).

7. Procédé selon l'une quelconque des revendications 1 à 6, dans lequel la couche active (13) comporte au moins une couche émissive (13.1) de puits quantique, et une couche barrière (13.2) située entre la première couche semiconductrice (11) et la couche émissive (13.1), la distance déterminée ($h_{1s}$) étant définie suivant un axe orthogonal au plan de la couche active (13), entre d'une part l'interface entre la couche d'extraction (6) et la première couche semiconductrice (11), et d'autre part un plan passant par la moitié de l'épaisseur de la couche émissive (13.1).

8. Procédé selon l'une quelconque des revendications 1 à 7, comportant une étape (300) de détermination d'une deuxième distance ($h_{2s}$) non nulle entre les dipôles optiques ($\mu_2$) associés aux particules nanométriques (6.1) et un milieu environnant s'étendant au contact d'une face supérieure (6a) de la couche d'extraction (6) opposée à la première couche semiconductrice (11), comportant les sous-étapes suivantes :

- choix (310) d'une orientation ($\theta_{2s}$) des dipôles optiques ($\mu_2$) vis-à-vis d'un plan de la couche d'extraction (6), parmi :

  - une orientation horizontale ($\theta_{2h}$) pour laquelle les dipôles optiques ($\mu_2$) sont orientés de manière parallèle au plan de la couche d'extraction (6), et
  - une orientation verticale ($\theta_{2v}$) pour laquelle les dipôles optiques ($\mu_2$) sont orientés de manière orthogonale au plan de la couche d'extraction (6) ;

- détermination (320, 330, 340) de la deuxième distance ($h_{2s}$) entre les dipôles optiques ($\mu_2$) et le milieu environnant, pour laquelle une durée de vie ($\tau_{n2,s}$) des dipôles optiques ($\mu_2$) présentant l'orientation choisie est supérieure à celle des dipôles optiques ($\mu_2$) présentant l'orientation non choisie ($\tau_{n2,ns}$),

  - à partir d'une fonction prédéterminée ($g_{h,v}$) exprimant une évolution d'un paramètre représentatif de la durée de vie d'un dipôle optique ($\mu_2$) présentant une orientation prédéfinie ($\theta_h$ ; $\theta_v$) en fonction de sa distance ($h_2$) au milieu environnant, compte tenu des propriétés optiques ($n_2$, $n_3$) de la couche d'extraction (6) et du milieu environnant ;
  - o réalisation (400) de la diode électroluminescente (1), une épaisseur du matériau diélectrique (6.2) de la couche d'extraction (6) étant telle que les dipôles optiques ($\mu_2$) sont situés à la deuxième distance déterminée ($h_{2s}$) vis-à-vis du milieu environnant, les dipôles optiques ($\mu_2$) étant alors orientés selon l'orientation choisie ($\theta_{2s}$) vis à vis du plan de la couche d'extraction (6).

9. Procédé selon la revendication 8, dans lequel l'étape de détermination (300) de la deuxième distance ($h_{2s}$) comporte les sous-étapes suivantes :

- détermination (320), sur une gamme de distance ($\Delta h_{2ref}$) prédéfinie, de l'évolution en fonction de la distance ($h_2$) du paramètre ($\tau_{n2,s}$) représentatif de la durée de vie du dipôle optique ($\mu_2$) présentant l'orientation choisie ($\theta_{2s}$), et de l'évolution en fonction de la distance ($h_2$) du paramètre ($\tau_{n,ns}$) représentatif de la durée de vie du dipôle optique ($\mu_2$) présentant l'orientation non choisie ($\theta_{2ns}$) ;
- détermination (330) d'un paramètre dit d'écart ($S_2$) représentatif d'un écart du paramètre ($\tau_{n2,s}$) représentatif de la durée de vie du dipôle optique ($\mu_2$) présentant l'orientation choisie ($\theta_{2s}$) vis-à-vis du paramètre ($\tau_{n2,ns}$) représentatif de la durée de vie du dipôle optique ($\mu_2$) présentant l'orientation non choisie ($\theta_{2ns}$), sur ladite gamme de distance ($\Delta h_{2ref}$) prédéfinie ;
- détermination (340) d'une distance ($h_{2s}$) non nulle de sorte que :

  - le paramètre ($\tau_{n2,s}$) représentatif de la durée de vie du dipôle optique ($\mu_2$) présentant l'orientation choisie ($\theta_{2s}$) est supérieur, pour la distance déterminée ($h_{2s}$), au paramètre ($\tau_{n2,ns}$) représentatif de la durée de vie du dipôle optique ($\mu_2$) présentant l'orientation non choisie ($\theta_{2ns}$), et que
  - le paramètre d'écart ($S_2$) présente, pour la distance déterminée ($h_{2s}$), une valeur maximale sur au moins une partie de la gamme de distance ($\Delta h_{2ref}$).

10. Procédé selon l'une quelconque des revendications 1 à 9, comportant :

  o une étape de détermination d'une troisième distance ($h_{1s'}$) non nulle entre les dipôles émetteurs ($\mu_1$) et une électrode réflectrice (4) s'étendant au contact de la deuxième couche semiconductrice (12), pour laquelle une durée de vie ($\tau_{n1',s}$) des dipôles émetteurs ($\mu_1$) présentant l'orientation verticale est supérieure à celle des

dipôles émetteurs ($\mu_1$) présentant l'orientation horizontale ($\tau_{n1',h}$),

• à partir d'une fonction prédéterminée ($g_{h,v}$) exprimant une évolution d'un paramètre représentatif de la durée de vie d'un dipôle émetteur ($\mu_1$) présentant une orientation prédéfinie ($\theta_h$ ; $\theta_v$) en fonction de sa distance ($h_{1'}$) à l'électrode réflectrice (4), compte tenu des propriétés optiques ($n_1$, $n_4$) de la couche active (13) et de la deuxième couche semiconductrice (12), et de l'électrode réflectrice (4) ;

o réalisation (400) de la diode électroluminescente (1), une épaisseur de la deuxième couche semiconductrice (12) étant telle que les dipôles émetteurs ($\mu_1$) sont situés à la troisième distance déterminée ($h_{1s'}$) vis-à-vis d'électrode réflectrice (4), les dipôles émetteurs ($\mu_1$) étant alors orientés de manière orthogonale au plan de la couche active (13).

**11.** Procédé selon la revendication 10, dans lequel l'électrode réflectrice (4) est une anode adaptée à injecter des trous dans l'empilement semiconducteur, et la deuxième couche semiconductrice (12) est réalisée en un matériau cristallin semiconducteur dopé de type P, ou réalisée en un matériau semiconducteur organique conducteur de trous.

**12.** Procédé selon l'une quelconque des revendications 1 à 11, dans lequel la première couche semiconductrice (11) est réalisée en un matériau cristallin semiconducteur dopé de type N, ou réalisée en un matériau semiconducteur organique conducteur d'électrons.

**Patentansprüche**

**1.** Verfahren zur Herstellung mindestens einer Leuchtdiode (1), die umfasst:

• einen halbleitenden Stapel, der aus einer ersten halbleitenden Schicht (11), einer zweiten halbleitenden Schicht (12) und einer zwischen den beiden halbleitenden Schichten (11, 12) gelegenen aktiven Schicht (13) gebildet ist, und
• eine Extraktionsschicht (6), die aus einem transparenten dielektrischen Material ausgeführt ist, das nanometrische Partikel (6.1) umfasst, und sich im Kontakt mit der ersten halbleitenden Schicht (11) erstreckt,

o wobei das Verfahren den folgenden Schritt umfasst:

o Wählen (100) der Materialien der ersten halbleitenden Schicht (11) und der aktiven Schicht (13) sowie der Extraktionsschicht (6),

wobei das Verfahren **dadurch gekennzeichnet ist, dass** es ferner die folgenden Schritte umfasst:

o Bestimmen (200) eines ersten Abstands ($h_{1s}$) ungleich null zwischen einerseits sogenannten Emitterdipolen ($\mu_1$), die den strahlenden Rekombinationen von Elektron-Loch-Paaren in der aktiven Schicht (13) zugeordnet sind, und andererseits der Extraktionsschicht (6), wobei:

• eine Lebensdauer ($T_{n,v}$) der Emitterdipole ($\mu_1$), die eine sogenannte vertikale Ausrichtung ($\theta_v$) entlang einer Achse senkrecht zur Ebene der aktiven Schicht (13) aufweisen, größer ist als die Lebensdauer ($T_{n,h}$) der Emitterdipole ($\mu_1$), die eine sogenannte horizontale Ausrichtung ($\theta_h$) entlang einer Achse parallel zur Ebene der aktiven Schicht (13) aufweisen,

- ausgehend von einer vorbestimmten Funktion ($g_{h,v}$), die einen Verlauf eines Parameters ausdrückt, der für die Lebensdauer eines Emitterdipols ($\mu_1$) repräsentativ ist, der eine vorgegebene Ausrichtung ($\theta_h$; $\theta_v$) aufweist, in Abhängigkeit von seinem Abstand ($h_1$) zu der Extraktionsschicht (6), unter Berücksichtigung der optischen Eigenschaften ($n_1$, $n_2$) der gewählten Materialien;

• optische Dipole ($\mu_2$), die den nanometrischen Partikeln (6.1) zugeordnet sind, im Nahfeld der Emitterdipole ($\mu_1$) gelegen sind, so dass eine nicht strahlende Kopplung vom Typ Dipol-Dipol zwischen den Emitterdipolen ($\mu_1$) und den optischen Dipolen ($\mu_2$) zugelassen wird;

o Ausführen (400) der Leuchtdiode (1), wobei eine Dicke der ersten halbleitenden Schicht (11) derart ist, dass die Emitterdipole ($\mu_1$) in dem bestimmten ersten Abstand ($h_{1s}$) gegenüber der Extraktionsschicht (6) gelegen sind, wobei die Emitterdipole ($\mu_1$) dann senkrecht zur Ebene der aktiven Schicht (13) ausgerichtet sind.

2. Verfahren nach Anspruch 1, bei dem die nanometrischen Partikel (6.1) Quantenpunkte sind, die aus halbleitenden Nanokristallen ausgeführt sind, und/oder aus mindestens einem metallischen Material ausgeführt sind.

3. Verfahren nach Anspruch 1 oder 2, bei dem die nanometrischen Partikel (6.1) einen mittleren Durchmesser zwischen 0,2 nm und 500 nm aufweisen.

4. Verfahren nach einem der Ansprüche 1 bis 3, bei dem sich die nanometrischen Partikel (6.1) in einer Ebene parallel zu der aktiven Schicht (13) erstrecken und an der Grenzfläche mit der ersten halbleitenden Schicht (11) angeordnet sind.

5. Verfahren nach einem der Ansprüche 1 bis 4, bei dem der bestimmte erste Abstand ($h_{1s}$) kleiner oder gleich 50 nm ist, wodurch die nicht strahlende Kopplung vom Typ Dipol-Dipol zwischen den Emitterdipolen ($\mu_1$) und den optischen Dipolen ($\mu_2$) optimiert wird.

6. Verfahren nach einem der Ansprüche 1 bis 5, bei dem der bestimmte erste Abstand ($h_{1s}$) entlang einer Achse senkrecht zur Ebene der aktiven Schicht (13) ausgehend von einer Grenzfläche zwischen der Extraktionsschicht (6) und der ersten halbleitenden Schicht (11) bis zu einer Ebene, die durch die Hälfte einer Dicke der aktiven Schicht (13) verläuft, definiert wird.

7. Verfahren nach einem der Ansprüche 1 bis 6, bei dem die aktive Schicht (13) mindestens eine emissive Quantentopfschicht (13.1) und eine zwischen der ersten halbleitenden Schicht (11) und der emissiven Schicht (13.1) gelegene Barriereschicht (13.2) umfasst, wobei der bestimmte Abstand ($h_{1s}$) entlang einer Achse senkrecht zur Ebene der aktiven Schicht (13) zwischen einerseits der Grenzfläche zwischen der Extraktionsschicht (6) und der ersten halbleitenden Schicht (11) und andererseits einer Ebene, die durch die Hälfte der Dicke der emissiven Schicht (13.1) verläuft, definiert wird.

8. Verfahren nach einem der Ansprüche 1 bis 7, umfassend einen Schritt (300) des Bestimmens eines zweiten Abstands ($h_{2s}$) ungleich null zwischen den optischen Dipolen ($\mu_2$), die den nanometrischen Partikeln (6.1) zugeordnet sind, und einem umgebenden Milieu, das sich im Kontakt mit einer Oberseite (6a) der Extraktionsschicht (6) erstreckt, die zu der ersten halbleitenden Schicht (11) entgegengesetzt ist, umfassend die folgenden Teilschritte:

• Wählen (310) einer Ausrichtung ($\theta_{2s}$) der optischen Dipole ($\mu_2$) gegenüber einer Ebene der Extraktionsschicht (6) unter:

- einer horizontalen Ausrichtung ($\theta_{2h}$), bei der die optischen Dipole ($\mu_2$) parallel zur Ebene der Extraktionsschicht (6) ausgerichtet sind, und
- einer vertikalen Ausrichtung ($\theta_{2v}$), bei der die optischen Dipole ($\mu_2$) senkrecht zur Ebene der Extraktionsschicht (6) ausgerichtet sind;

• Bestimmen (320, 330, 340) des zweiten Abstands ($h_{2s}$) zwischen den optischen Dipolen ($\mu_2$) und dem umgebenden Milieu, bei dem eine Lebensdauer ($T_{n2,s}$) der optischen Dipole ($\mu_2$), die die gewählte Ausrichtung aufweisen, größer ist als die der optischen Dipole ($\mu_2$), die die nicht gewählte Ausrichtung ($T_{n2,ns}$) aufweisen,

- ausgehend von einer vorbestimmten Funktion ($g_{h,v}$), die einen Verlauf eines Parameters ausdrückt, der für die Lebensdauer eines optischen Dipols ($\mu_2$) repräsentativ ist, der eine vorgegebene Ausrichtung ($\theta_h$; $\theta_v$) aufweist, in Abhängigkeit von seinem Abstand ($h_2$) zum umgebenden Milieu, unter Berücksichtigung der optischen Eigenschaften ($n_2$, $n_3$) der Extraktionsschicht (6) und des umgebenden Milieus;
o Ausführen (400) der Leuchtdiode (1), wobei eine Dicke des dielektrischen Materials (6.2) der Extraktionsschicht (6) derart ist, dass die optischen Dipole ($\mu_2$) in dem bestimmten zweiten Abstand ($h_{2s}$) gegenüber dem umgebenden Milieu gelegen sind, wobei die optischen Dipole ($\mu_2$) dann entlang der gewählten Ausrichtung ($\theta_{2s}$) gegenüber der Ebene der Extraktionsschicht (6) ausgerichtet sind.

9. Verfahren nach Anspruch 8, bei dem der Schritt des Bestimmens (300) des zweiten Abstands ($h_{2s}$) die folgenden Teilschritte umfasst:

- Bestimmen (320), über einen vorgegebenen Abstandsbereich ($\Delta h_{2ref}$), des Verlaufs in Abhängigkeit vom Abstand ($h_2$) des Parameters ($T_{n2,s}$), der für die Lebensdauer des optischen Dipols ($\mu_2$) repräsentativ ist, der die gewählte Ausrichtung ($\theta_{2s}$) aufweist, und des Verlaufs in Abhängigkeit vom Abstand ($h_2$) des Parameters ($T_{n,ns}$), der für die Lebensdauer des optischen Dipols ($\mu_2$) repräsentativ ist, der die nicht gewählte Ausrichtung ($\theta_{2ns}$) aufweist;

- Bestimmen (330) eines sogenannten Abweichungsparameters ($S_2$), der für eine Abweichung des Parameters ($T_{n2,s}$) repräsentativ ist, der für die Lebensdauer des optischen Dipols ($\mu_2$) repräsentativ ist, der die gewählte Ausrichtung ($\theta_{2s}$) aufweist, gegenüber dem Parameter ($T_{n2,ns}$), der für die Lebensdauer des optischen Dipols ($\mu_2$) repräsentativ ist, der die nicht gewählte Ausrichtung ($\theta_{2ns}$) aufweist, über den vorgegebenen Abstandsbereich ($\Delta h_{2ref}$);

- Bestimmen (340) eines Abstands ($h_{2s}$) ungleich null, so dass:

  - der Parameter ($T_{n2,s}$), der für die Lebensdauer des optischen Dipols ($\mu_2$) repräsentativ ist, der die gewählte Ausrichtung ($\theta_{2s}$) aufweist, größer ist, für den bestimmten Abstand ($h_{2s}$), als der Parameter ($T_{n2,ns}$), der für die Lebensdauer des optischen Dipols ($\mu_2$) repräsentativ ist, der die nicht gewählte Ausrichtung ($\theta_{2ns}$) aufweist, und dass

  - der Abweichungsparameter ($S_2$), für den bestimmten Abstand ($h_{2s}$), einen Maximalwert über mindestens einen Teil des Abstandsbereichs ($\Delta h_{2ref}$) aufweist.

10. Verfahren nach einem der Ansprüche 1 bis 9, umfassend:

    o einen Schritt des Bestimmens eines dritten Abstands ($h_{1s'}$) ungleich null zwischen den Emitterdipolen ($\mu_1$) und einer reflektierenden Elektrode (4), die sich im Kontakt mit der zweiten halbleitenden Schicht (12) erstreckt, wobei eine Lebensdauer ($T_{n1',s}$) der Emitterdipole ($\mu_1$), die die vertikale Ausrichtung aufweisen, größer ist als die der Emitterdipole ($\mu_1$), die die horizontale Ausrichtung ($T_{n1',h}$) aufweisen,

    - ausgehend von einer vorbestimmten Funktion ($g_{h,v}$), die einen Verlauf eines Parameters ausdrückt, der für die Lebensdauer eines Emitterdipols ($\mu_1$) repräsentativ ist, der eine vorgegebene Ausrichtung ($\theta_h$; $\theta_v$) aufweist, in Abhängigkeit von seinem Abstand ($h_{1'}$) zur reflektierenden Elektrode (4), unter Berücksichtigung der optischen Eigenschaften ($n_1$, $n_4$) der aktiven Schicht (13) und der zweiten halbleitenden Schicht (12) und der reflektierenden Elektrode (4);

    o Ausführen (400) der Leuchtdiode (1), wobei eine Dicke der zweiten halbleitenden Schicht (12) derart ist, dass die Emitterdipole ($\mu_1$) in dem bestimmten dritten Abstand ($h_{1s'}$) gegenüber der reflektierenden Elektrode (4) gelegen sind, wobei die Emitterdipole ($\mu_1$) dann senkrecht zur Ebene der aktiven Schicht (13) ausgerichtet sind.

11. Verfahren nach Anspruch 10, bei dem die reflektierende Elektrode (4) eine Anode ist, die dazu angepasst ist, Löcher in den halbleitenden Stapel zu injizieren, und die zweite halbleitende Schicht (12) aus einem P-dotierten halbleitenden kristallinen Material ausgeführt ist oder aus einem lochleitenden organischen halbleitenden Material ausgeführt ist.

12. Verfahren nach einem der Ansprüche 1 bis 11, bei dem die erste halbleitende Schicht (11) aus einem N-dotierten halbleitenden kristallinen Material ausgeführt ist oder aus einem elektronenleitenden organischen halbleitenden Material ausgeführt ist.

## Claims

1. A method for producing at least one light-emitting diode (1) comprising:

   - a semiconductor stack formed of a first semiconductor layer (11), of a second semiconductor layer (12), and of an active layer (13) located between the two semiconductor layers (11, 12), and
   - an extraction layer (6), made of a transparent dielectric material comprising nanoscale particles (6.1), extending in contact with the first semiconductor layer,

     o the method comprising the following step:

       o choosing (100) the materials of the first semiconductor layer (11) and of the active layer (13), and of the extraction layer (6);

o the method being **characterized in that** it comprises the following steps:

o determining (200) a first non-zero distance ($h_{1s}$) between, on the one hand, emitting dipoles ($\mu_1$) associated with the radiative recombination of electron-hole pairs in the active layer (13) and, on the other hand, the extraction layer (6), for which:

• a lifetime ($\tau_{n,v}$) of the emitting dipoles ($\mu_1$), having a vertical orientation ($\theta_v$) along an axis orthogonal to the plane of the active layer (13), is longer than the lifetime ($\tau_{n,h}$) of the emitting dipoles ($\mu_1$) having a horizontal orientation ($\theta_h$) along an axis parallel to the plane of the active layer (13),

- on the basis of a predetermined function ($g_{h,v}$) expressing a change in a parameter representative of the lifetime of an emitting dipole ($\mu_1$) having a predefined orientation ($\theta_h$; $\theta_v$) according to its distance ($h_1$) from the extraction layer (6), taking into account optical properties ($n_1$, $n_2$) of said materials chosen;

• optical dipoles ($\mu_2$) associated with the nanoscale particles (6.1) are located in the near field of the emitting dipoles ($\mu_1$), so as to allow non-radiative coupling of dipole-dipole type between the emitting dipoles ($\mu_1$) and the optical dipoles ($\mu_2$);

o producing (400) the light-emitting diode (1), a thickness of the first semiconductor layer (11) being such that the emitting dipoles ($\mu_1$) are located at the first determined distance ($h_{1s}$) with respect to the extraction layer (6), the emitting dipoles ($\mu_1$) then being oriented orthogonally to the plane of the active layer (13).

2. The method as claimed in claim 1, wherein the nanoscale particles (6.1) are quantum dots made of semiconductor nanocrystals, and/or are made of at least one metal material.

3. The method as claimed in claim 1 or 2, wherein the nanoscale particles (6.1) have a mean diameter of between 0.2 nm and 500 nm.

4. The method as claimed in any one of claims 1 to 3, wherein the nanoscale particles (6.1) extend in a plane parallel to the active layer (13), and are arranged at the interface with the first semiconductor layer (11).

5. The method as claimed in any one of claims 1 to 4, wherein the first determined distance ($h_{1s}$) is smaller than or equal to 50 nm, thus optimizing the non-radiative coupling of dipole-dipole type between the emitting dipoles ($\mu_1$) and the optical dipoles ($\mu_2$).

6. The method as claimed in any one of claims 1 to 5, wherein the first determined distance ($h_{1s}$) is defined along an axis orthogonal to the plane of the active layer (13), from an interface between the extraction layer (6) and the first semiconductor layer (11) to a plane passing through halfway through a thickness of the active layer (13).

7. The method as claimed in any one of claims 1 to 6, wherein the active layer (13) comprises at least one quantum well emissive layer (13.1), and a barrier layer (13.2) located between the first semiconductor layer (11) and the emissive layer (13.1), the determined distance ($h_{1s}$) being defined along an axis orthogonal to the plane of the active layer (13), between, on the one hand, the interface between the extraction layer (6) and the first semiconductor layer (11), and, on the other hand, a plane passing through halfway through the thickness of the emissive layer (13.1).

8. The method as claimed in any one of claims 1 to 7, comprising a step (300) of determining a second non-zero distance ($h_{2s}$) between the optical dipoles ($\mu_2$) associated with the nanoscale particles (6.1) and a surrounding medium extending in contact with an upper face (6a) of the extraction layer (6) opposite the first semiconductor layer (11), comprising the following sub-steps:

• choosing (310) an orientation ($\theta_{2s}$) of the optical dipoles ($\mu_2$) with respect to a plane of the extraction layer (6), from among:

- a horizontal orientation ($\theta_{2h}$) for which the optical dipoles ($\mu_2$) are oriented so as to be parallel to the plane of the extraction layer (6), and
- a vertical orientation ($\theta_{2v}$) for which the optical dipoles ($\mu_2$) are oriented so as to be orthogonal to the plane of the extraction layer (6);

- determining (320, 330, 340) the second distance ($h_{2s}$) between the optical dipoles ($\mu_2$) and the surrounding medium, for which a lifetime ($\tau_{n2,s}$) of the optical dipoles ($\mu_2$) having the chosen orientation is longer than that of the optical dipoles ($\mu_2$) having the non-chosen orientation ($\tau_{n2,ns}$),

> - on the basis of a predetermined function ($g_{h,v}$) expressing a change in a parameter representative of the lifetime of an optical dipole ($\mu_2$) having a predefined orientation ($\theta_h$; $\theta_v$) according to its distance ($h_2$) from the surrounding medium, taking into account the optical properties ($n_2$, $n_3$) of the extraction layer (6) and of the surrounding medium;
>
> o producing (400) the light-emitting diode (1), a thickness of the dielectric material (6.2) of the extraction layer (6) being such that the optical dipoles ($\mu_2$) are located at the second determined distance ($h_{2s}$) with respect to the surrounding medium, the optical dipoles ($\mu_2$) then being oriented according to the chosen orientation ($\theta_{2s}$) with respect to the plane of the extraction layer (6).

9. The method as claimed in claim 8, wherein the step (300) of determining the second distance ($h_{2s}$) comprises the following sub-steps:

> - determining (320), over a predefined distance range ($\Delta h_{2ref}$), the change according to distance ($h_2$) in the parameter ($\tau_{n2,s}$) representative of the lifetime of the optical dipole ($\mu_2$) having the chosen orientation ($\theta_{2s}$), and the change according to distance ($h_2$) in the parameter ($\tau_{n,ns}$) representative of the lifetime of the optical dipole ($\mu_2$) having the non-chosen orientation ($\theta_{2ns}$);
> - determining (330) a difference parameter ($S_2$) representative of a difference in the parameter ($\tau_{n2,s}$) representative of the lifetime of the optical dipole ($\mu_2$) having the chosen orientation ($\theta_{2s}$) with respect to the parameter ($\tau_{2n,ns}$) representative of the lifetime of the optical dipole ($\mu_2$) having the non-chosen orientation ($\theta_{2ns}$), over said predefined distance range ($\Delta h_{2ref}$);
> - determining (340) a non-zero distance ($h_{2s}$) such that:
>
>> - the parameter ($\tau_{n2,s}$) representative of the lifetime of the optical dipole ($\mu_2$) having the chosen orientation ($\theta_{2s}$) is greater, for the determined distance ($h_{2s}$), than the parameter ($\tau_{n2,ns}$) representative of the lifetime of the optical dipole ($\mu_2$) having the non-chosen orientation ($\theta_{2ns}$), and that
>> - the difference parameter ($S_2$) has, for the determined distance ($h_{2s}$), a maximum value over at least a portion of the distance range ($\Delta h_{2ref}$).

10. The method as claimed in any one of claims 1 to 9, comprising:

> o a step of determining a third non-zero distance ($h_{1s'}$) between the emitting dipoles ($\mu_1$) and a reflective electrode (4) extending in contact with the second semiconductor layer (12), for which a lifetime ($\tau_{n1',s}$) of the emitting dipoles ($\mu_1$) having the vertical orientation is longer than that of the emitting dipoles ($\mu_1$) having the horizontal orientation ($\tau_{n1',h}$),
>
>> - on the basis of a predetermined function ($g_{h,v}$) expressing a change in a parameter representative of the lifetime of an emitting dipole ($\mu_1$) having a predefined orientation ($\theta_h$; $\theta_v$) according to its distance ($h_{1'}$) from the reflective electrode (4), taking into account the optical properties ($n_1$, $n_4$) of the active layer (13) and of the second semiconductor layer (12), and of the reflective electrode (4);
>
> o producing (400) the light-emitting diode (1), a thickness of the second semiconductor layer (12) being such that the emitting dipoles ($\mu_1$) are located at the third determined distance ($h_{1s'}$) with respect to the reflective electrode (4), the emitting dipoles ($\mu_1$) then being oriented orthogonally to the plane of the active layer (13).

11. The method as claimed in claim 10, wherein the reflective electrode (4) is an anode capable of injecting holes into the semiconductor stack, and the second semiconductor layer (12) is made of a P-doped semiconductor crystalline material, or is made of a hole-conducting organic semiconductor material.

12. The method as claimed in any one of claims 1 to 11, wherein the first semiconductor layer (11) is made of an N-doped semiconductor crystalline material, or is made of an electron-conducting organic semiconductor material.

**Fig.1A**

**Fig.1B**

**Fig.2A**

**Fig.2B**

**Fig.3A**

**Fig.3B**

100 — $n_1, n_2 (n_3)$

200 {

210 — $\forall h_1 \in \Delta h_{1ref}, \ \tau_{n1,v} = g_h(h_1) ; \tau_{n1,h} = g_v(h_1)$

220 — $h_{1s} / \tau_{n1,v}(h_{1s}) > \tau_{n1,h}(h_{1s})]$

300 {

310 — $\theta_{2s} = \{ \theta_h ; \theta_v \}$

320 — $\forall h_2 \in \Delta h_{2ref}, \ \tau_{n2,v} = g_h(h_2) ; \tau_{n2,h} = g_v(h_2)$

330 — $\forall h_2 \in \Delta h_{2ref}, \ |S_2(h_2)| = |\tau_{n2,s}(h_2) - \tau_{n2,ns}(h_2)|$

340 — $h_{2s} / \tau_{n2,s}(h_{2s}) > \tau_{n2,ns}(h_{2s})]$
$|S(h_{2s})| = \max_{\Delta h2ref}(|S(h_2)|)$

400

**Fig.4**

**Fig.5A**

**Fig.5B**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2014008676 A1
- US 2012153254 A1
- EP 1855327 A2
- EP 2362448 A1

**Littérature non-brevet citée dans la description**

- **SCHMIDT et al.** Emitter Orientation as a Key Parameter in Organic Light-Emitting Diodes. *Phys. Rev. Applied,* 2017, vol. 8, 037001
- **NOVOTNY ; HECHT.** Principles of Nano-Optics. Cambridge University Press, 2006, 344